# EUROPEAN PATENT SPECIFICATION

(11) **EP 3 631 478 B1**
(45) Date of publication and mention of the grant of the patent: **02.11.2022**
(21) Application number: 18726194.6
(22) Date of filing: 30.05.2018
(51) Int. Cl.: G01R 29/08, H04B 17/00, H04W 24/00, H04B 7/04, G01R 29/10, H04B 17/391, H04W 24/06

(54) **APPARATUSES, METHODS AND A MEASUREMENT SYSTEM FOR CHARACTERIZING A WIRELESS COMMUNICATION COMPONENT USABLE IN NON-ANECHOIC ENVIRONMENTS**
VORRICHTUNGEN, VERFAHREN UND MESSSYSTEM ZUR CHARAKTERISIERUNG EINER IN NICHT-ECHOFREIEN UMGEBUNGEN NUTZBAREN DRAHTLOSEN KOMMUNIKATIONSKOMPONENTE
APPAREILS, PROCÉDÉS ET SYSTÈME DE MESURE POUR CARACTÉRISER UN ÉLÉMENT DE COMMUNICATION SANS FIL UTILISABLE DANS DES ENVIRONNEMENTS NON ANÉCHOÏQUES

(30) Priority: 31.05.2017 EP 17173796
(43) Date of publication of application: 08.04.2020
(73) Proprietor: Fraunhofer-Gesellschaft zur Förderung der angewandten Forschung e.V., 80686 München (DE)
(72) Inventor: LEATHER, Paul Simon Holt, 14169 Berlin (DE); HAUSTEIN, Thomas, 14469 Potsdam (DE)
(74) Representative: Burger, Markus
(86) International application number: PCT/EP2018/064301
(87) International publication number: WO 2018/220084

(56) References cited:
- US-A1- 2006 055 592
- US-A1- 2011 230 143

## Description

Embodiments of the present invention describe apparatuses, methods and a measurement system for characterizing a wireless communication component.

### Background of the Invention

Multipath propagation effects can cause signal distortion in a variety of communication systems including those used for cellular radio (e.g. LTE, WCDMA, GSM, TETRA), wireless local area networks (e.g. 802.11x) and domestic FM broadcasts. Fortunately, there are a number of electronic techniques that mitigate such effects and in some systems, even exploit them. Common to all techniques is the requirement for multiple reception and/or transmission antennas that provide different versions of the same signal. This is known as an antenna diversity system or a multiple input multiple output (MIMO) system. In reception mode, the multiple input signals are electronically combined to produce a composite signal with lower average distortion than any of the individual inputs. In transmission mode, the signals are electronically distributed in such a way that when propagated, they can be combined optimally upon reception. Alternatively, in transmission mode, the signals are electronically distributed in such a way that, after propagation, they can be combined optimally upon reception. As another alternative, in transmission mode, the signals are electronically distributed in such a way that when, having been propagated, they can be combined optimally. Combinations of single or multiple input transmission, and single or multiple output reception are possible. MIMO systems can thus be designed to provide improved coverage, capacity, efficiency and reliability, for both single user and multiple user applications. The performance of such systems depends on the antennas, the radio equipment and the propagation environment in which the system operates. A need therefore exists to evaluate the performance of the equipment in different conditions for which over-the-air (OTA) measurements are necessary.

An established method of evaluating the performance of mobile radio systems is to install the equipment and antennas under test into a test vehicle and then drive along predefined routes, each with its own unique set of properties. As the demand for high-speed mobile data increases (e.g. 4G and beyond 4G), so do the demands placed on the radio circuitry and hence the testing of that design.

Testing radio communication systems in the field is time-consuming and expensive since there are uncertainties in the statistical variations actually encountered. Extensive trials therefore have to be undertaken to ensure the results are truly representative of all the conditions likely to be encountered in practice. It is clearly attractive to test systems in the laboratory since conditions can then be tightly controlled, but it is very important to ensure that all the relevant properties of the signal can be adequately simulated. The major decision that has to be taken is whether to use a hardware or software simulation or a combination of both. It is also necessary to decide, in the light of the intended application, whether simulation of the channel as a frequency-selective medium is necessary (wideband simulation) or whether a simpler non-frequency-selective, multipath simulation (narrowband simulation) is sufficient. Regardless however of which approach is taken, laboratory measurements require the use of a so-called anechoic chamber - a dedicated test facility comprised of an electrically-shielded room of specific dimensions, lined with radiation absorbing material arranged in such a manner as to reduce electromagnetic field reflections or signal echoes. The chamber may further comprise antenna positioning equipment - such as a turntable or multi-axis positioner - multiple measurement probes, or hybrid combinations of the two.

Currently there are three possible methods. The first involves the installation of equipment and antennas into a test vehicle and physically driving through different propagation environments (such as rural, urban, sub-urban and highway). Automation of such so-called drive tests is possible within the framework of 3GPP Technical Specification TS37.320 [1].

The second and third methods rely on testing in a laboratory, relying thereupon an anechoic chamber in one and a reverberation chamber in the other [2].

Anechoic chamber measurements can be done in various ways. In the radiated two-stage (RTS) process, the results of antenna pattern measurements are combined with the results of performance measurements made using fading simulators connected to the inputs of the equipment. This requires access to the electrical or galvanic interface between the equipment's circuitry and its antennas. In highly-integrated equipment, in which the transceiver electronics and the antenna array are combined, an electrical interface between the two is not possible. An alternative measurement process (which also solves the problem created by the absence of the radio-antenna-interface connector) is to measure the antennas and the equipment in a single-stage process, in which multiple probes, positioned around the device under test, are connected to fading simulators and other test equipment.

In the stirred-wave or reverberation chamber method, rotating paddles are positioned so as to deliberately create a multipath environment within the confines of the cavity. This removes the need for fading simulators to some extent.

The drive testing method has the disadvantage that the propagation environment is not controllable whereas the anechoic chamber requires a dedicated and often large volume of space reserved for the sole purpose of antenna-related measurements in which the simultaneous measurement of more than one device under test is not possible. Reverberation chambers suffer similar drawbacks and are inherently less flexible. Obtaining fading profiles with repeatable signal statistics can also present considerable challenges.

US 2011/0230143 A1 describes a method and device in over-the-air test environments. A device and method for simulating a radio channel with a defined characteristic between at least one antenna port of a first device and a second device in a test environment is described. The device comprises a first antenna adapted to receive signals and arranged to provide a first radio channel between the first antenna and the second device and a second antenna adapted to receive signals and arranged to provide a second radio channel between the second antenna and a second device. A characteristic of the second radio channel is dissimilar to a characteristic of the first radio channel. The device further comprises a modifying circuit adapted to modify an amplitude relation between the received signals, and a multiport circuit arranged to connect the first and second antennas with the at least one antenna port. The multiport circuit is also adapted to combine the modified signals, and to forward the combined signal to the at least one antenna port, thereby simulating a radio channel between the at least one antenna port and the second device with a characteristic which is a combination of the characteristic of the second radio channel and the characteristic of the first radio channel in a relation corresponding to the modified amplitude relation.

In view of the mentioned conventional approaches, there exists a desire for an improved concept to characterize wireless communication components.

### Summary of the Invention

Embodiments according to the present invention are defined by the independent claims. Moreover, it should be noted that any embodiments disclosed herein which do not comprise all features of one of the independent claims should be considered as examples helpful for understanding aspects of the present invention.

An embodiment according to a first aspect of the invention provides an apparatus for characterizing a wireless communication component. The apparatus is configured to process a receive signal, such that an effect of multipath propagation in a characterization environment is at least partially compensated and such that a predetermined distortion is introduced, to thereby emulate a virtual electromagnetic environment. The characterization can be, for example, be a testing, the wireless communication component can, for example, be an antenna, a mobile station or a base station, and the predetermined distortion may also be considered as fading.

The described embodiment is based on the idea that measurements of wireless communication component in a non-anechoic environment can be more cost-effective than an anechoic chamber. Moreover, the embodiment is further based on the idea that introduction of the predetermined distortion, e.g., in a controlled manner, can, for example, simulate a desired multiple path propagation profile. Thereby, the apparatus enables measurement of wireless communication components in an arbitrary environment, wherein an influence of the arbitrary environment is at least partially compensated. Further, a controlled predetermined distortion can be introduced to, for example, emulate a fading, according to a desired multipath propagation.

In an embodiment according to the first aspect, the apparatus is configured to apply a timing-invariant filtering to introduce a static filtering contribution, to at least partially compensate an effect of multipath propagation. Further, the apparatus is configured to apply a time-variant filtering contribution to introduce the predetermined distortion. The described apparatus can remove or at least partially compensate, any distortion due to multipath propagation, which is time invariant as the wireless communication component and the apparatus may be arranged in a static manner in a static environment. Further, the time-variant filtering contribution to introduce the predetermined distortion may serve to emulate a time varying fading according to a mobile channel.

In embodiments according to the first aspect, the apparatus is configured to introduce the predetermined distortion by weighting spectral values of the received signal with predetermined fading coefficients. The described embodiment can efficiently perform the introduction of the predetermined distortion by multiplication in the frequency domain.

In embodiments according to the first aspect, the apparatus may be configured to introduce a predetermined distortion, such that a fading of a mobile channel between the wireless component and the apparatus is emulated. The described embodiment can beneficially emulate a fading between a wireless component, e.g., a mobile device and a base station; here, the apparatus. Thereby, fading simulations can be performed in a fast, reliable and reproducible manner.

In embodiments according to the first aspect, the apparatus may be configured to introduce the predetermined distortion, such that the apparatus emulates a motion of the wireless communication component, wherein the motion is emulated to be in an environment different to a test environment. The described embodiment can flexibly and reliably perform motion simulations of a mobile device and a base station, which are moving relative to each other.

In embodiments according to the first aspect, the apparatus may be configured to introduce the predetermined distortion, such that the apparatus emulates a desired multipath propagation. The described embodiment can advantageously simulate an influence of a desired multipath propagation between the apparatus and the wireless communication component.

In embodiments according to the first aspect, the apparatus is configured to convolve the received signal with a predetermined impulse response, such that the convolution achieves the predetermined distortion. The predetermined impulse response may, for example, be an impulse response of a fading profile and therefore achieve a desired fading.

In embodiments according to the first aspect, the apparatus is configured to obtain a filter or filter coefficients, by using a reception of a reference signal. Furthermore, the apparatus is configured to use the obtained filter, e.g., to process the received signal, to at least partially compensate the effect of multipath propagation of the characterization environment. The filter coefficients of the obtained filter may, for example, be associated to an inverse of an impulse response of the characterization environment, thereby an influence of the characterization environment on the signal is at least partially compensated.

In embodiments according to the first aspect, the apparatus comprises a plurality of probes configured to obtain a plurality of received signals. Moreover, the apparatus is configured to allow for a variable adjustment of a contribution of one or more of the received signals, or of contributions of the received signals, to a provision of an output signal. The described embodiment can perform an improved measurement by usage of a plurality of received signals and moreover, is able to configure contributions of the received signals to the measurement.

In embodiments according to the first aspect, the apparatus may be configured to variably adjust the contribution of one or more of the received signals in a time-varying manner. The described embodiment can flexibly change over time, for example, it can change a look-direction of the apparatus by variably adjusting the contributions with the one or more received signals.

In embodiments according to the first aspect, the apparatus may be configured to emulate a motion of the wireless communication component, e.g., a relative motion with respect to the wireless communication component, by varying the contribution of one or more of the received signals to the output signal. The described embodiment can flexibly use the one or more received signals to simulate a motion of the wireless component relative to the apparatus, thereby allowing simulation of real-world movement, for example, between a mobile device and a base station.

In embodiments according to the first aspect, the apparatus may be configured to variably adjust a contribution of one or more of the received signals by weighting and combining two or more of the received signals. The usage of weighting and combination allows for simple adjustment of the variable contributions of the one or more received signals.

In embodiments according to the first aspect, the apparatus may be configured to adjust the weighting such that a beamforming is obtained, in order to variably adjust a contribution of one or more of the received signals. The described embodiment can enable a beamforming such that the apparatus is focusing its probes or antennas into a desired receive direction or a number of desired receive directions. The use of a number of desired receive directions enables measurement of a component that creates multiple beams.

In embodiments according to the first aspect, the apparatus may be configured to individually filter at least one of the at least two received signals and to consequently combine the at least two received signals to obtain the output signal, such that the output signal provides for a special selectivity. Using filters allows for an output signal with a higher spatial selectivity as side lobes of an antenna pattern of the antennas or probes of the apparatus can be better suppressed.

In embodiments according to the first aspect, the apparatus may be configured to obtain information about a desired electromagnetic environment through an interface. Further, the apparatus may be configured to adjust the predetermined distortion according to the information about the desired electromagnetic environment, and/or to set a variable adjustment of a contribution of one or more received signals according to the information about the desired electromagnetic environment. The described apparatus can flexibly obtain its parameters through the interface and thereby adjust the predetermined distortion or the variable adjustment of the contributions of one or more received signals. In embodiments according to the first aspect, the apparatus may comprise a filter, e.g. a single or a common filter, which is configured to at least partially compensate a multipath propagation in a characterization environment, and/or to introduce a predetermined distortion and/or to allow for a variable adjustment of a contribution of one or more received signals. The described embodiment advantageously may combine the individual features into one filter, wherein the filter may only comprise two of the mentioned three features.

An embodiment according to a second aspect of the invention provides an apparatus for characterizing a wireless communication component, wherein the apparatus comprises at least two measurement probes. Further, the apparatus is configured to process at least two signals received via the at least two measurement probes, such that an effect of multipath propagation in a characterization environment is at least partially compensated. Moreover, the apparatus is configured to allow for a variable adjustment of a contribution of one or more of the received signals (or of contributions of the received signals) to a provision of an output signal, to thereby emulate a virtual electromagnetic environment. The characterization may also be defined as a testing, and the wireless communication component may, for example, be an antenna, a mobile station or a base station. Furthermore, the at least two measurement probes are, for example, antennas.

The described embodiment is based on the idea that a fast and cheap characterization of a wireless communication component can be performed in an arbitrary environment using the compensation. Moreover, the multipath propagation of the arbitrary environment is at least partially compensated by the apparatus, and therefore does not influence the characterization significantly. Furthermore, through the variable adjustment of the contributions of the one or more received signals, a flexible characterization apparatus is provided, which can, for example, be used to make directional dependent measurements or characterizations of the wireless communication component.

In embodiments according to the second aspect, the apparatus may be configured to variably adjust the contribution of one or more of the received signals in a time varying manner. The described embodiment can beneficially adjust a contribution to the output signal of the at least two received signals in a time-varying manner, such that, for example, a time-varying propagation profile is achieved.

In embodiments according to the second aspect, the apparatus may be configured to emulate a motion, e.g., a relative motion, of the wireless communication component, by varying the contribution of one or more of the received signals to the output signal. The described embodiment can beneficially simulate a motion of a wireless communication component, e.g., a mobile device, to an apparatus which may be seen as a base station, while in a static environment. Thereby, fast measurements of mobile devices can be performed with desired motion profiles.

In embodiments according to the second aspect, the apparatus may be configured to variably adjust the contribution of two or more of the received signals by weighting and combining two or more of the received signals. Weighting and combining can be implemented in a fast and simple way, such that a low computation complexity is secured.

In embodiments according to the second aspect, the apparatus may be configured to adjust the weighting such that a beamforming is obtained, in order to variably adjust a contribution of one or more of the received signals. By beamforming, the apparatus can be configured to focus its listening reception to a desired point or to receive a signal from the wireless communication component from a predominant direction or a number of desired directions. The direction may be chosen such that a desired multipath propagation profile may be achieved.

In embodiments according to the second aspect, the apparatus may be configured to individually filter at least the one of the at least two received signals and to consequently combine the at least two received signals to obtain the output signal, such that the output signal provides for a spatial selectivity. Using a filtering of the received signals and a subsequent combination may yield an output signal with a higher spatial selectivity, i.e., having, for example, a narrower main lobe and lower side lobes.

An embodiment according to a third aspect of the invention provides an apparatus for characterizing, e.g., testing, a wireless communication component, e.g., an antenna, mobile station or a base station. The apparatus is configured to process a transmit signal, such that an effect of multipath propagation in a characterization environment is at least partially compensated at a position of the wireless communication component. Further, the apparatus is configured to transmit the processed transmit signal to the wireless communication component.

The described embodiment is based on the idea that when performing measurements of a wireless communication component in an arbitrary environment, a measurement signal may be received at the wireless communication component distorted by a multipath propagation. Therefore, appropriately processing the transmit signal prior to sending it to the wireless communication component at least partially compensates the effect of multipath propagation at the position of the wireless communication component. Thereby, characterizations and tests of the wireless communication component independent from the characterization environment may be performed.

In embodiments according to the third aspect, the apparatus may be configured to apply a filtering to the transmit signal or to at least partially compensate for an effect of multipath propagation in a characterization environment in a position of the wireless communication component. The described embodiment can use a simple filtering operation to remove unwanted distortions to the signal by filtering the transmit signal.

In embodiments according to the third aspect, the apparatus may be configured to determine a filter, or filter coefficients or several filters, to at least partially compensate for an effect of multipath propagation in a characterization environment. Further, determining the filter may comprise estimating an inverse of an impulse response of the characterization environment, e.g., between one or more probes of the apparatus and the position of the wireless communication component. Using a filter with filter coefficients which are the inverse of the impulse response of the characterization environment yields a simple way of compensating distortions introduced due to the characterization environment.

In embodiments according to the third aspect, the apparatus may be configured to obtain a filter to at least partially compensate the effect of multipath propagation of the characterization environment, by using a reception of a reference signal. Using a reference signal in the apparatus and in the wireless communication component enables a simple computation of the filter. For example, by using a correlation or an adaptive filtering algorithm, such as the least mean square algorithm, recursive least square or affine projection algorithm, the filter coefficients can be easily obtained based on the reference signal.

In embodiments according to the third aspect, the apparatus may be configured to process the transmit signal, such that a predetermined distortion is introduced, to thereby emulate a virtual electromagnetic environment at a position of the wireless communication component. The described embodiment may flexibly introduce a desired distortion at the wireless communication component, for testing the wireless communication component.

In embodiments according to the third aspect, the apparatus may be configured to apply a filtering to the transmit signal which introduces a static filtering contribution, to at least partially compensate an effect of multipath propagation at a position of the wireless communication component. Further, the filtering introduces a time-varying filtering contribution to introduce the predetermined distortion at the position of the wireless communication component. As a measurement environment may be static using a filtering which introduces a static filtering contribution, may sufficiently reduce distortions due to multipath propagation. Furthermore, allowing for the predetermined distortion to be time-varying allows for flexible measurement of various predetermined distortion profiles.

In embodiments according to the third aspect, the apparatus may be configured to introduce the predetermined distortion by weighting spectral values of the transmit signal with predetermined fading coefficients or weighting coefficients. Using a weighting of spectral values enables a fast computation of the introduction of the predetermined distortion.

In embodiments according to the third aspect, the apparatus may be configured to introduce the predetermined distortion, such that a fading of a mobile channel between the wireless communication component and the apparatus is emulated. The described embodiment is beneficial as it flexibly allows simulation of a desired fading profile, therefore facilitating testing of varying fading profiles, while the apparatus of the wireless communication component remains in a static environment. Thereby, a controllable and fast testing of the wireless communication component can be achieved.

In embodiments according to the third aspect, the apparatus may be configured to introduce the predetermined distortion, such that the apparatus emulates a motion, e.g., a relative motion, of the wireless communication component in an environment different to a test environment. The described embodiment allows simulating flexibly various test settings, while the apparatus or the wireless communication component may remain static.

In embodiments according to the third aspect, the apparatus may be configured to introduce the predetermined distortion, such that the apparatus emulates a desired multipath propagation. By emulating a desired multipath propagation, the apparatus allows for flexible measurements of arbitrary multipath propagation profiles.

In embodiments according to the third aspect, the apparatus may comprise at least two probes and the apparatus may be configured to transmit a transmit signal using one or more of the at least two probes. The described embodiment can flexibly assign a transmit signal to one or more probes and thereby produce a virtual electromagnetic environment.

In embodiments according to the third aspect, the apparatus may be configured to transmit a transmit signal using two or more probes, e.g., at the same time. The described embodiment may use one transmit signal and transmit it using two probes.

In embodiments according to the third aspect, the apparatus may be configured to flexibly distribute two or more transmit signals, such that the at least two probes are configurable in a first state, in which the respective probe transmits no transmit signal and in a second state in which the respective probe transmits a signal which is based on a signal of the two or more transmit signals, and a third state in which the respective probe transmits a signal which is based on a combination of the two or more transmit signals. The described embodiment can flexibly distribute two or more transmit signals to the at least two probes, such that a desired virtual electromagnetic environment is achieved. Furthermore, one of the signals may be a desired signal and a second transmit signal may be an interfering signal. A reception of the desired signal may be used in the wireless communication component to assess the link performance.

In embodiments according to the third aspect, the apparatus may be configured to variably adjust a contribution of one or more transmit signals to the at least two probes. The described embodiment allows a flexible allocation of a transmit signal to the at least two probes.

In embodiments according to the third aspect, the apparatus may be configured to variably adjust a contribution of one or more of the transmit signals in a time-varying manner. Allowing a time-varying contribution of the one or more transmit signals allows for a flexible design of a virtual electromagnetic environment.

In embodiments according to the third aspect, the apparatus may be configured to emulate a motion, e.g., a relative motion, of the wireless communication component by varying the contribution of one or more of the transmit signals to the at least two probes. The described embodiment beneficially enables a simulation of a movement of either the apparatus or the wireless communication component, while no actual movement may be necessary.

In embodiments according to the third aspect, the apparatus may be configured to variably adjust a contribution of one or more of the transmit signals, by individually weighting a transmit signal assigned to a probe or a transmit signal assigned to one or more probes. The described embodiment can flexibly route transmit signals to individual probes with weighting, such that a spatial selectivity may be obtained.

In embodiments according to the third aspect, the apparatus may be configured to adjust the weighting of the transmit signals such that a beamforming is obtained. A beamforming can be used to simulate a desired signal impinging on the wireless communication component from one direction and an interfering signal impinging from another direction on the wireless communication component. Alternatively, the beamforming can be used to simulate an impinging from multiple directions. Thereby, a high flexibility of the virtual electromagnetic environment can be achieved.

In embodiments according to the third aspect, the apparatus may be configured to individually filter at least one of the at least two transmit signals and to consequently distribute the at least two transmit signals to the at least two probes, such that the apparatus provides for a spatial selectivity. The described embodiment may achieve a beamforming with a high spatial selectivity. The high spatial selectivity can lead to narrow main lobes and attenuated side lobes of a beam pattern of the apparatus. Moreover, a high spatial selectivity can also lead to the creation of specific nulls in a beam pattern of the apparatus.

An embodiment of the invention provides for a measurement system comprising an apparatus according to the first aspect and/or an apparatus according to the second aspect, and/or an apparatus according to the third aspect. Further, the one or more apparatuses are arranged in a non-anechoic chamber. The described measurement system allows for testing and characterization of the wireless communication component in a conventional room, which may be echoic, saving the expenses for an anechoic chamber.

In embodiments the measurement system may comprise an evaluator which is configured to evaluate a link performance between the one or more apparatuses and the wireless communication component. The described system allows for a flexible characterization of the wireless communication component.

In embodiments of the measurement system, the evaluator may be configured to evaluate the link performance in the presence of emulated fading. The described system allows for measurement of wireless communication components in an arbitrary environment, while a desired virtual electromagnetic environment is emulated.

In embodiments of the measurement system, the evaluator may be configured to evaluate the link performance in the presence of emulated motion. The described embodiment allows for characterization of the wireless communication component while at rest, to perform as if it would be in motion.

An embodiment according to the first aspect provides a method of characterizing a wireless communication component. A method comprises processing a received signal, such that an effect of multipath propagation in a characterization environment is at least partially compensated and such that a predetermined distortion is introduced, to thereby emulate a virtual electromagnetic environment.

An embodiment according to a second aspect provides a method for characterizing a wireless communication component. The method comprises processing at least two signals received via at least two measurement probes, such that an effect of multipath propagation in a characterization environment is at least partially compensated. Further, the method comprises variably adjusting a contribution of one or more of the received signals to a provision of an output signal.

An embodiment according to the third aspect provides a method for characterizing a wireless communication component. The method comprises processing a transmit signal, such that an effect of multipath propagation in a characterization environment is at least partially compensated at a position of the wireless communication component. Further, the method comprises transmitting the processed transmit signal to the wireless communication component.

The described methods can be supplemented either individually or in combination by any features or functionalities described herein with respect to the apparatuses.

An embodiment provides for a computer program with a program code for performing one of the methods according to the first, second or third aspect on a computer or a microcontroller.

### Brief Description of the Figures

In the following, embodiments of the present invention will be explained with reference to the accompanying drawings, in which:
- Fig. 1: shows a schematic block diagram of an apparatus according to embodiments of the first aspect of the invention;
- Fig. 2: shows a schematic block diagram of an apparatus according to embodiments of the second aspect of the invention;
- Fig. 3: shows a schematic block diagram of an apparatus according to embodiments of the third aspect of the invention;
- Fig. 4A: shows a typical usage scenario which may be emulated by embodiments of the invention;
- Fig. 4B: shows a typical usage scenario which may be emulated by embodiments of the invention;
- Fig. 4C: shows a typical usage scenario which may be emulated by embodiments of the invention;
- Fig. 5A: shows a test system according to embodiments of the invention in an uplink setting;
- Fig. 5B: shows a test system according to embodiments of the invention in a downlink setting;
- Fig. 6: shows a schematic block diagram of an apparatus for compensation of multipath propagation usable in an uplink scenario;
- Fig. 7: shows a schematic block diagram of an apparatus for compensation of multipath propagation according to embodiments of the third aspect of the invention, usable in a downlink scenario;
- Fig. 8: shows a schematic block diagram of an adaptive filter structure, using a tapped delay line;
- Fig. 9A: shows a schematic block diagram of a measurement system according to embodiments of the invention;
- Fig. 9B: shows a schematic block diagram of a measurement system according to embodiments of the invention;
- Fig.10A: shows a schematic block diagram of a measurement system according to embodiments of the invention;
- Fig. 10B: shows a schematic block diagram of a measurement system according to embodiments of the invention;
- Fig.11A: shows a schematic block diagram of a measurement system according to embodiments of the invention;
- Fig. 11B: shows a schematic block diagram of a measurement system according to embodiments of the invention;
- Fig. 12A: shows a schematic block diagram of an apparatus according to embodiments of the first or the second aspect of the invention;
- Fig. 12B: shows a schematic block diagram of an apparatus according to embodiments of the third aspect of the invention;
- Fig. 13: shows a schematic block diagram of an apparatus according to embodiments of the third aspect of the invention;
- Fig. 14: shows a schematic block diagram of a measurement system according to embodiments of the invention;
- Fig. 15: shows a schematic of a measurement setup;
- Fig. 16: shows a schematic of a probe or antenna arrangement;
- Fig. 17: shows a flow chart of a method according to embodiments of the first aspect of the invention;
- Fig. 18: shows a flow chart of a method according to embodiments of the second aspect of the invention;
- Fig. 19: shows a flow chart of a method according to embodiments of the third aspect of the invention.

### Detailed Description of the Embodiments

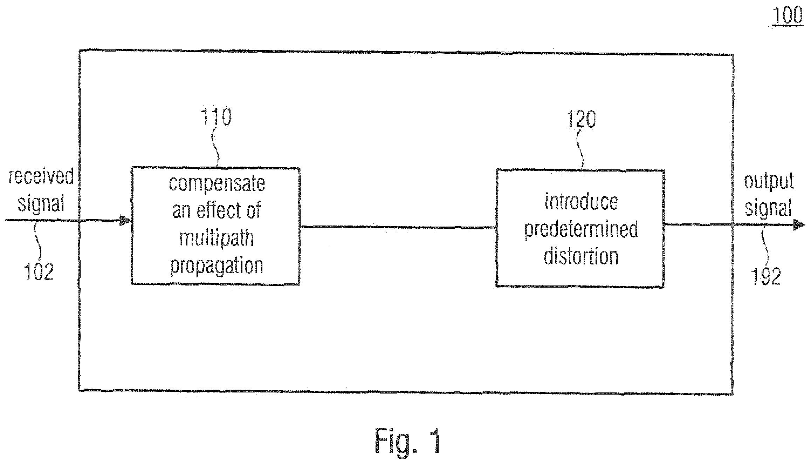

Fig. 1 shows a schematic block diagram of an apparatus 100 according to embodiments of the invention for characterizing a wireless communication component. The apparatus 100 is configured to process a received signal 102, such that an effect of multipath propagation in a characterization environment is at least partially compensated for, using compensator 110 and such that a predetermined distortion is introduced, using distortion introducer 120, to thereby emulate a virtual electromagnetic environment. The apparatus 100 provides a processed received signal 102 as output signal 192.

The apparatus 100 can be flexibly used to, for example, emulate a virtual electromagnetic environment, by compensating for an effect of a current environment and introducing the predetermined distortion according to a desired environment. The apparatus 100 can therefore be used to test a wireless communication component in an arbitrary environment, while not being effected by the environment. Moreover, by introducing the predetermined distortion, a desired virtual electromagnetic environment can be achieved in which a wireless communication component is to be tested.

The described embodiment can be supplemented either individually or in combination by any features or functionalities described herein with respect to following embodiments. Embodiments of different aspects of the invention can also be combined to increase the overall functionality of the embodiments.

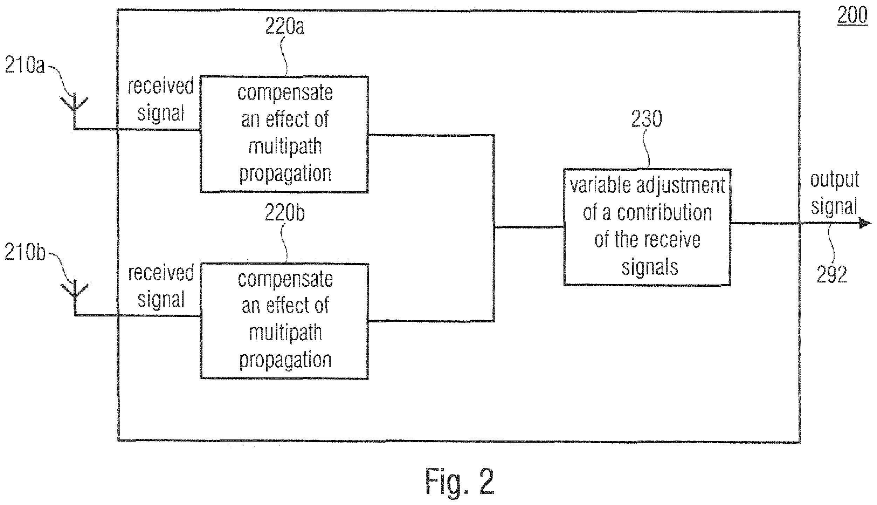

Fig. 2 shows a schematic block diagram of an apparatus 200 according to embodiments of the second aspect of the invention, for characterizing a wireless communication component. The apparatus 200 comprises at least two measurement probes, measurements probes 210a and 210b. Furthermore, the apparatus is configured to process at least two signals received by the at least two measurement probes, e.g., antennas, such that an effect of multipath propagation in a characterization environment is at least partially compensated for. The compensation can be performed with compensators 220a and 220b. Moreover, the apparatus 200 is configured to allow for a variable adjustment of a contribution of one or more of the received signals, using adjuster 230, to a provision of an output signal 292.

The described embodiment can be flexibly used to test a wireless communication component in an arbitrary environment. By usage of the compensators 220a and 220b, an effect of the arbitrary environment is at least partially compensated for, such that a signal is obtained that resembles reception in an anechoic chamber. Furthermore, by variably adjusting contributions of the received signals, a spatial selectivity can be obtained, allowing for an emulation of a directionality of the received signals. Thereby, scattering profiles can be emulated which, for example, have a focusing effect on a signal transmitted by the wireless communication component.

The described embodiment can be supplemented either individually or in combination by any features or functionalities described herein with respect to following embodiments. Embodiments of different aspects of the invention can also be combined to increase the overall functionality of the embodiments.

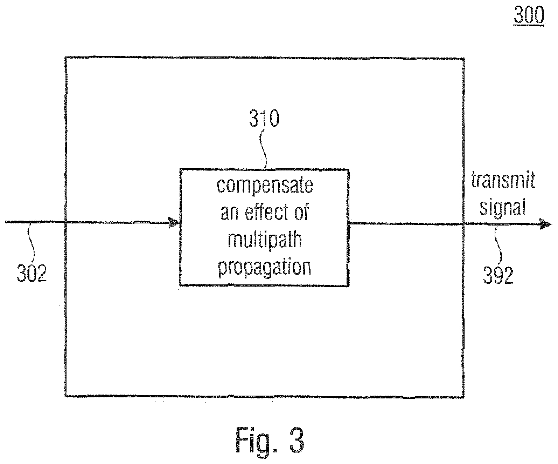

Fig. 3 shows a schematic block diagram of an apparatus 300 according to embodiments of the third aspect of the invention, for characterizing a wireless communication component. The apparatus 300 is configured to process a transmit signal 302, such that an effect of multipath propagation in a characterization environment is at least partially compensated for, using compensator 310, in a position of the wireless communication component and to transmit the processed signal to the wireless communication component.

The described embodiment is able to compensate for an effect of multipath propagation at the location of the wireless communication component. Thereby, the wireless communication component, although being placed, for example, in an anechoic environment, receives a signal as if no multipath propagation or echoes are present. Therefore, the described embodiment can be used to perform characterizations or tests of the wireless communication component, which would usually be done in an anechoic chamber. Thereby, use of an expensive anechoic chamber can be avoided.

The described embodiment can be supplemented either individually or in combination by any features or functionalities described herein with respect to following embodiments. Embodiments of different aspects of the invention can also be combined to increase the overall functionality of the embodiments.

In the following typical scenarios for emulating virtual electromagnetic environments are discussed, which can be emulated by usage of apparatuses 100, 200 or 300. For example, the predetermined distortion introduced by the apparatus 100 can be adjusted to emulate the fading of the scenarios described in the following. Moreover, the variable adjustment of contributions of received signals of apparatus 200 may be used to emulate the scenarios described in the following.

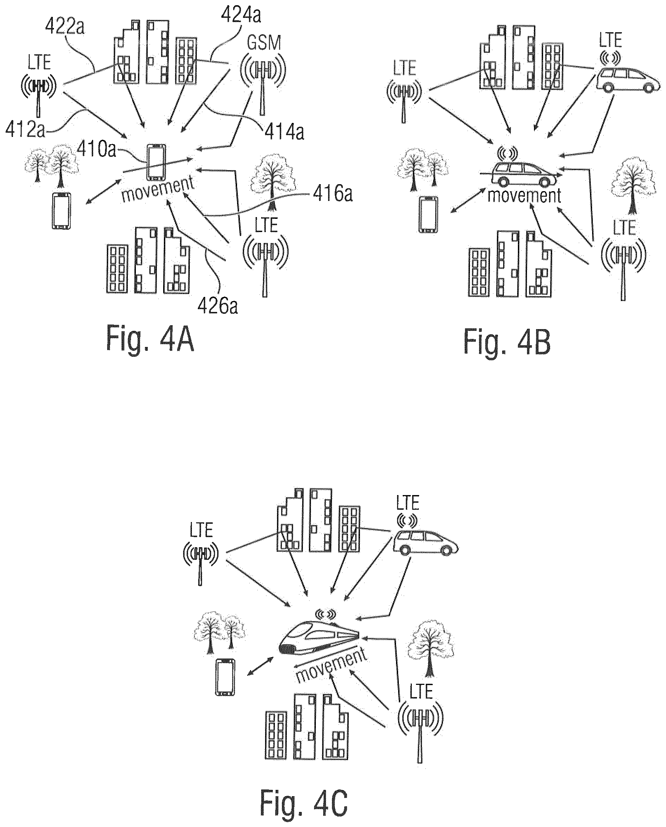

Figs 4A, 4B and 4B show a simplified pictorial representation of Fig 4A pedestrian, Fig. 4B vehicular and Fig. 4C high-speed train radiocommunications propagation environments comprised of scatterers and blockers.

Fig. 4A shows a typical usage scenario of a mobile phone 410a which receives signals from varying base stations while moving. The signals from various base stations may be base stations of an LTE or GSM system, and can be received by the mobile phone 410a, via a direct line of sight connection, e.g., 412a, 414a or 416a. The mobile phone 410 can also receive signals from the base stations through scattered reflections, e.g., 422a, 424a, 426a. Moreover, the mobile phone 410a can also receive signals from another mobile phone. The mobile phone in the scenario of Fig. 4A is, for example, carried by a pedestrian and therefore, only subjected to a slow movement. The direct line of sight and scattering lead to a fading of received signals of the mobile phone 410a, which is only slowly changing as the mobile phone is moving comparably slowly.

Fig. 4B shows a similar mobile reception scenario to Fig. 4A. In contrast to Fig. 4A, the mobile phone in Fig. 4B is in a moving car and another mobile phone is situated in another car, acting as a non-stationary source of interference. Further, the mobile phone in Fig. 4B also suffers from multipath propagation, but due to its faster movement than a pedestrian, the multipath propagation is changing faster, thereby leading to a fast fading channel.

Fig. 4C shows again a similar scenario to Fig. 4A and Fig. 4B, but in contrast to Figs. 4A and 4B, the mobile phone is now situated in a moving train. As the train can be considered to move faster than a car or a pedestrian, the multipath propagation observed by a mobile phone in a train is changing much faster.

To conclude, the three scenarios depicted in Fig. 4A, 4B and 4C are examples of scenarios which may be emulated using apparatuses 100, 200 or 300.

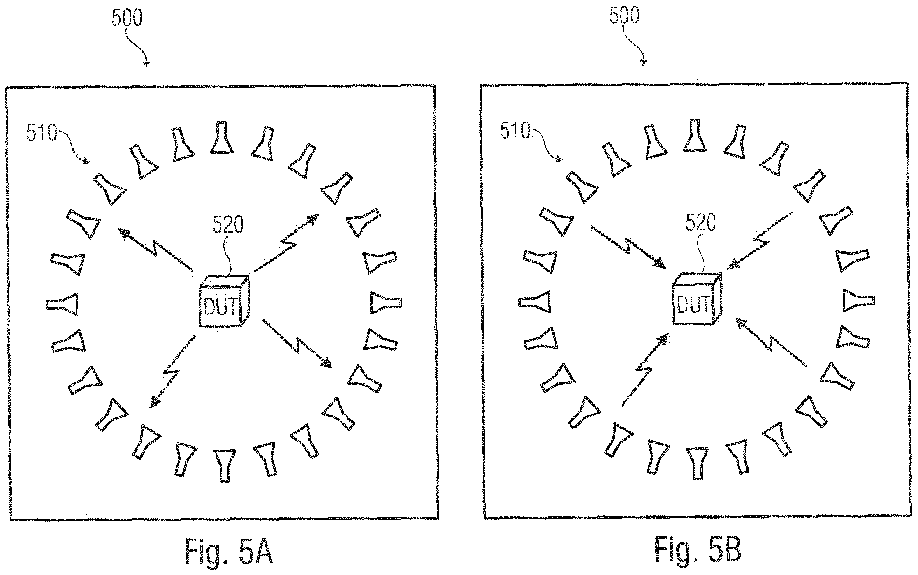

Figs. 5A and 5B show a multiprobe antenna measurement system which may be enclosed inside a shielded room operating Fig. 5A from device under test (DUT) to measurement equipment (uplink) and Fig. 5B from measurement equipment to DUT (downlink).

Fig. 5A shows a test system 500, having multiple probes 510 which may be connected to one of the apparatuses 100, 200 or 300. The probes 510 are located in a circle around a device under test 520. The device under test 520 emits a signal which is received by the probes 510 and subsequently processed by one of the apparatuses 100 or 200, or a combination of both. The scenario in Fig. 5A shows a so-called uplink scenario as the device under test 520 transmits a signal which is received by the probes 510.

Fig. 5B shows the system 500 with the same probes 510 in the so-called downlink scenario. In the downlink scenario, the probes 510 emit a signal which the device under test 520 receives.

In the scenario depicted in Fig. 5A, the received signal may then be subjected to tests to evaluate a link performance. Similarly, in Fig. 5B, the received signal of the device under test 520 may also be subjected to tests to evaluate the link performance in the downlink case, i.e., the device under test receives a signal from the probes 510.

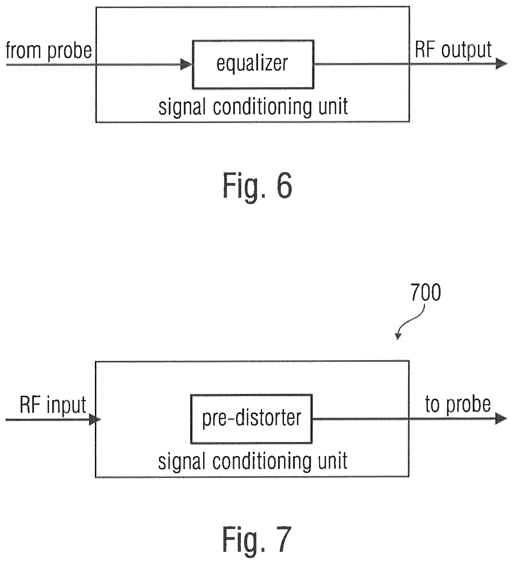

Fig. 6 shows an apparatus for equalizing multipath propagation, which takes a signal from a probe, feeds it to an equalizer, performing the compensation of the multipath propagation, and providing an output. Further, Fig. 6 shows a concept of DUT to over the air (OTA) equalization applied to the uplink.

Fig. 7 shows a schematic block diagram of an apparatus 700 according to embodiments of the third aspect of the invention. The apparatus 700 takes an input signal and feeds it to a pre-distorter, which conditions the signal such that it is received at a point of the wireless communication component as if no multipath propagation, or only a small amount of multipath propagation, took place, although being in a reverberant environment. Therefore, apparatus 700 can be used to perform tests of the so-called downlink scenario in an arbitrary environment. Further, Fig. 7 shows a concept of OTA to DUT pre-distortion applied to the downlink.

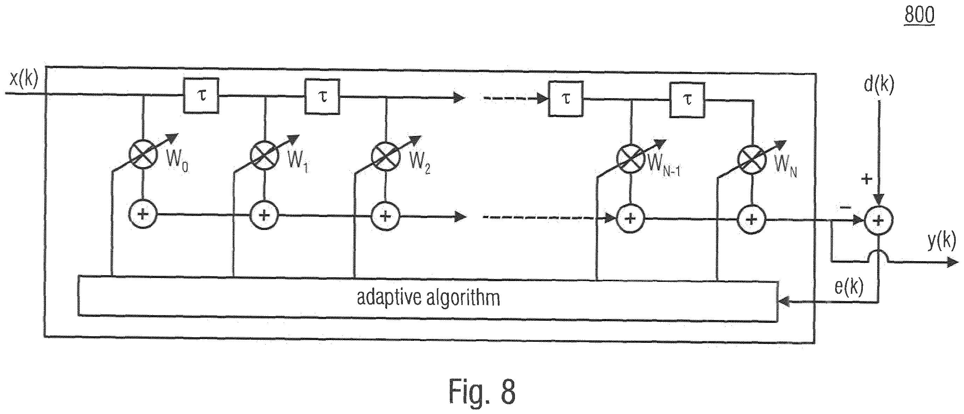

Fig. 8 shows a filter structure 800 which can be used, to estimate filter coefficients, to compensate an effect of multipath propagation. In other words, Fig. 8 shows a tapped delay line equalizer showing Input (x), output (y), error (e) and desired signal (d) connections. The filter coefficients w₀, w₁, w₂.....w_{N-1} and w_{N} can be adapted to an arbitrary environment and afterwards used in a filter or compensator, for example, a compensator 110, compensators 220a and 220b, or compensator 310. For adaptation of the weights w₀ to w_{N}, a known reference signal may be used which is known at the wireless communication component and one of the apparatuses 100, 200 or 300.

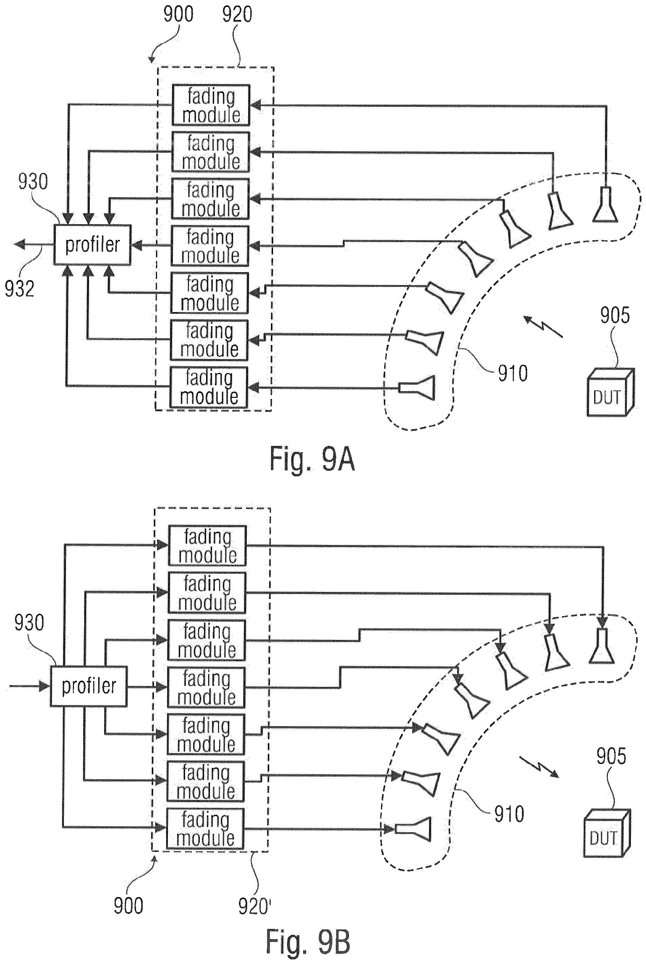

Fig. 9A and Fig. 9B show a measurement system 900 according to embodiments of the invention, in an uplink scenario and a downlink scenario, respectively. The system 900 comprises probes 910 which in the uplink scenario receive a signal from the device under test and process it in fading modules 920. The fading modules 920 can introduce a predetermined distortion, to achieve a desired fading profile. Moreover, the fading modules are arranged in paths to each of the probes 910, such that each probe can be subjected to an individual fading. The output signals of the fading modules 920 are fed to a profiler 930 which choses individual signals, combines or weights the individual probe signals, to provide the output signal 932. Based on the output signal 932 the system 900 can then evaluate a link performance between the device under test 905 in the uplink scenario. Moreover, the system 900 can subject the link to a desired fading profile through the use of the fading modules 920 and, further, can also introduce a desired spatial selectivity through the use of the profiler 930.

In Fig. 9B, the system 900 is depicted in the so-called downlink scenario, i.e., the device under test receives signals or a signal from the system 900. The same functional blocks, i.e., the fading modules 920' and the profiler 930, are also employed in the downlink scenario. The fading module 920' introduces a desired fading profile onto the connection between the system 900 and the device under test 905. The profiler 930 can flexibly assign signals to each of the fading modules and consequently to each probe. Whereas some probes may obtain no signal and other probes may receive multiple signals with individual weighting. In the downlink scenario depicted in Fig. 9B, the evaluation of the link performance is preferably performed in the device under test, or in a device or evaluator connected to the device under test 905.

In other words, Fig. 9A and 9B show a multiprobe combined antenna and radio measurement system enclosed inside a shielded room (not shown) comprised of a profiler and fading modules operating Fig. 9A from DUT to measurement equipment (uplink) and Fig. 9B from measurement equipment to DUT (downlink).

The functionality of the fading modules 920, 920' and the profiler 930 can also be introduced into any of the other embodiments described herein.

The system 900 is preferably employed in an anechoic environment, as it does not comprise an equalizer or a pre-distorter.

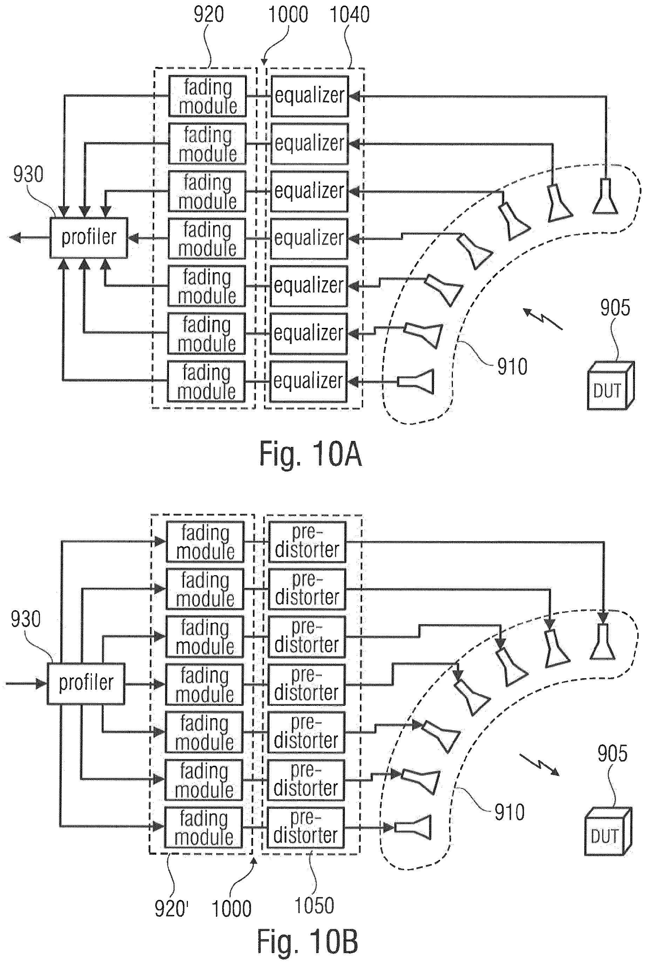

Figs.10A and 10B show schematic block diagrams of a system 1000 which is similar to the system 900 and comprises the same functional blocks, i.e., profiler 930, fading module 920 and probes 910. Further to the system 900, the system 1000 comprises, for the compensation of multipath propagation, an equalizer 1040 or pre-distorter 1050. The pre-distorter may for example correspond to the block 310 of the apparatus 300 and the equalizer 1040 may for example correspond to the block 110, 210a or 210b of the apparatuses 100 or 200. The fading module 920 may correspond to block 120 of apparatus 100. The profilers 930 may correspond to block 230 of the apparatus 200. In the uplink case, i.e., a signal is received from the device under test 905, the equalizers 1040 are compensating a reverberation effect of an environment in which the device under test 905 in the apparatus 1000 is placed. Furthermore, in the downlink scenario, i.e., a signal is emitted to the device under test 905, the apparatus 1050 pre-distorts a signal sent to the device under test 905, such that it is received at the location of the device under test 905 without or with only minimal multipath propagation effects. Thereby, the system 1000 allows flexible measurement of a device under test 905 in an arbitrary environment which may or may not have reverberation, and therefore avoids the need of an expensive anechoic chamber. Moreover, using the fading modules 920 and the profiler 930, a desired virtual electromagnetic environment can be achieved, under which the device under test 905 can be tested. The system 1000 can comprise an evaluator which evaluates the link performance in the uplink or the downlink case, either based on a signal provided by the system 1000 or a signal provided by the device under test 905, respectively.

Alternatively, Figs. 10A and 10B show a multiprobe combined antenna and radio measurement system in a non-anechoic environment comprised of a profiler and fading modules operating Fig. 10A from DUT to measurement equipment (uplink) and Fig. 10B from measurement equipment to DUT (downlink).

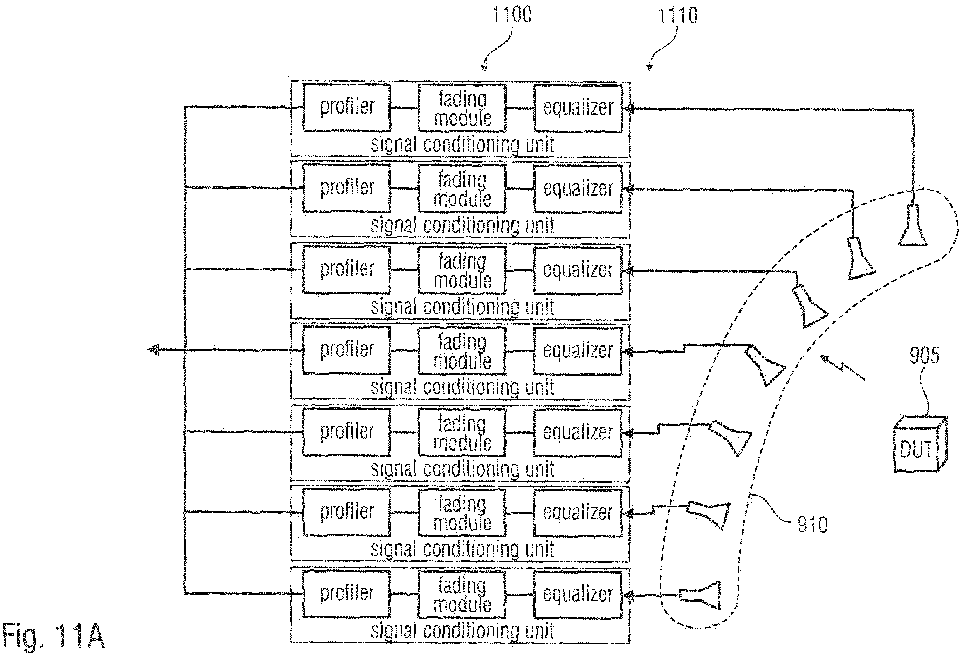

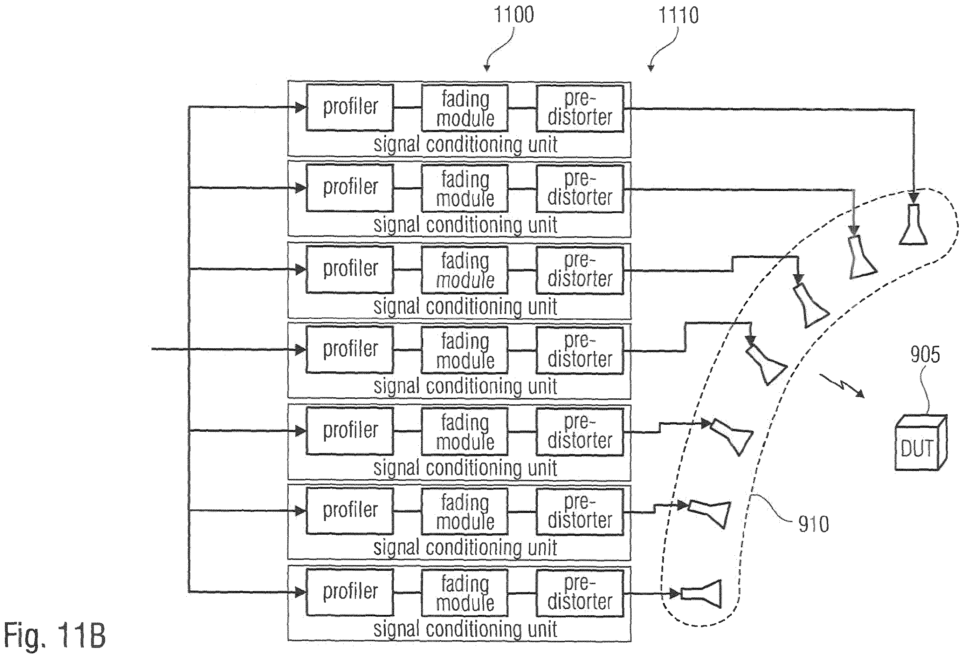

Figs. 11A and 11B show a system 1100 which shows a reconfiguration of the system 1000. The profilers 930 and 930' from system 1000 are split into the individual signal paths and combined with the fading modules and equalizers and pre-distorters into one unit. An equal or similar functionality, compared to the functionality of system 1000, is obtained with system 1100.

Alternatively, Figs. 11A and 11B show a multiprobe combined antenna and radio measurement system in a non-anechoic environment comprised of signal conditioning units operating Fig. 11A from DUT to measurement equipment (uplink) and Fig. 11B from measurement equipment to DUT (downlink).

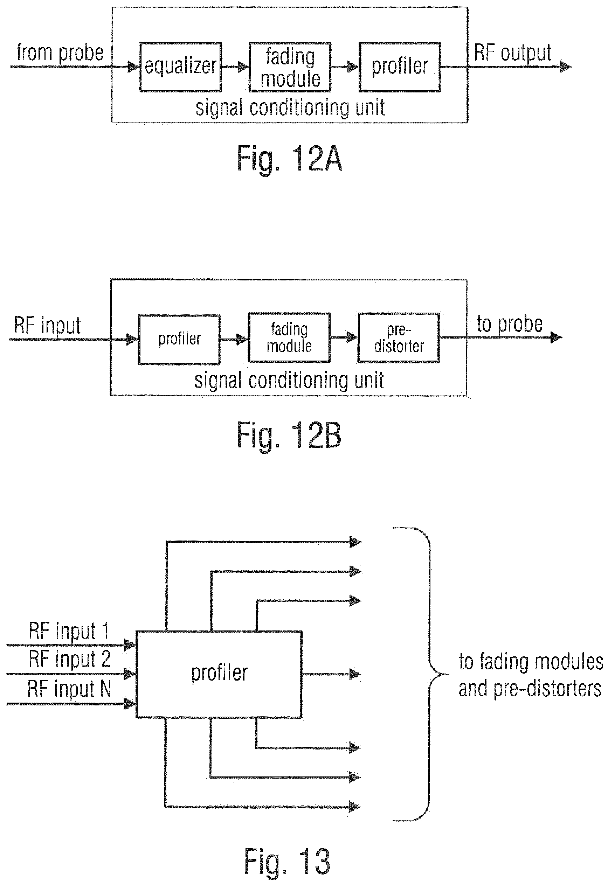

In system 1100, the profiler, equalizer and fading modules are joined into a single signal conditioning unit which is shown in more detail in Figs. 12A and 12B. In other words, the functionalities of blocks 110, 120 may be performed by a single signal conditioning unit. Similarly, functionalities of blocks 220a, 220b and 230 can be optionally performed by single signal conditioning unit. However, other functionalities may also be included. Fig. 12A shows further a concept of equalization applied to OTA-in-VEE used in a non-anechoic chamber. Fig. 12B shows further a concept of pre-distortion applied to OTA-in-VEE used in a non-anechoic chamber.

Fig. 13 shows a profiler which takes multiple RF input signals, of which one or more may be desired signals and others may be interference and distributes individual contributions of the input signals to the probes, or fading modules and pre-distorters which in turn may supply the probes with signals. In other words, Fig.13 shows A profiler used in a VEE comprised of multiple RF signals comprised of both "wanted" and "unwanted" transmissions in the downlink.

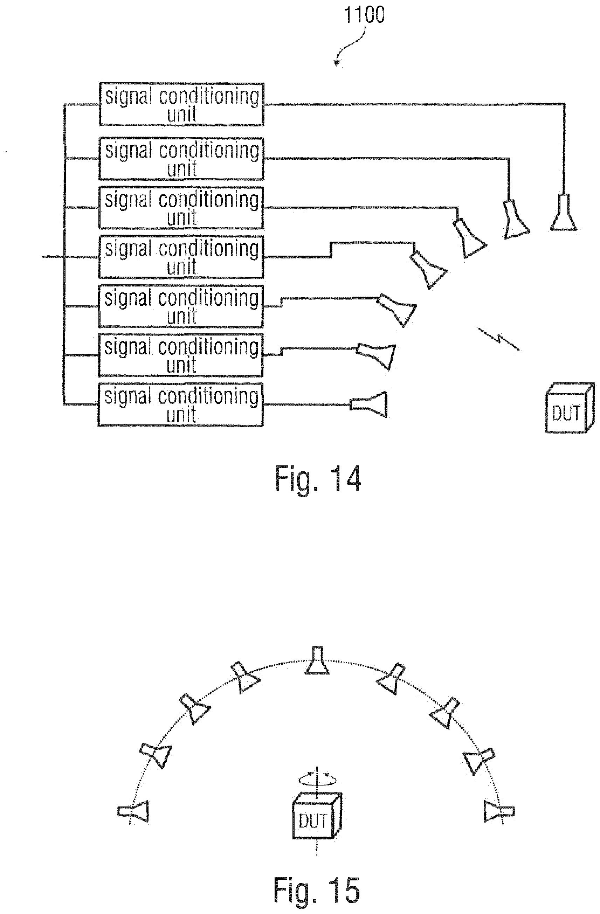

Fig. 14 shows an alternative depiction of system 1100, where the processing is moved into signal conditioning units in the individual signal path of the probes. The signal conditioning units may be similar to the signal conditioning units 1100. Alternatively, Fig. 14 shows a multiprobe combined antenna and radio measurement system in a non-anechoic environment comprised of signal conditioning units for either uplink or downlink measurements.

Fig. 15 shows an arrangement of probes and a device under test. The arrangement of probes is only semi-circular and to obtain a measurement of the device under test along a whole hemisphere, a rotation of the device under test is suggested. Thereby, the number of probes can be reduced while still having the ability to measure larger volumes. Fig. 15 shows further, a multiprobe system comprised of antennas arranged in an arc and requiring mechanical rotation of the DUT about its axis.

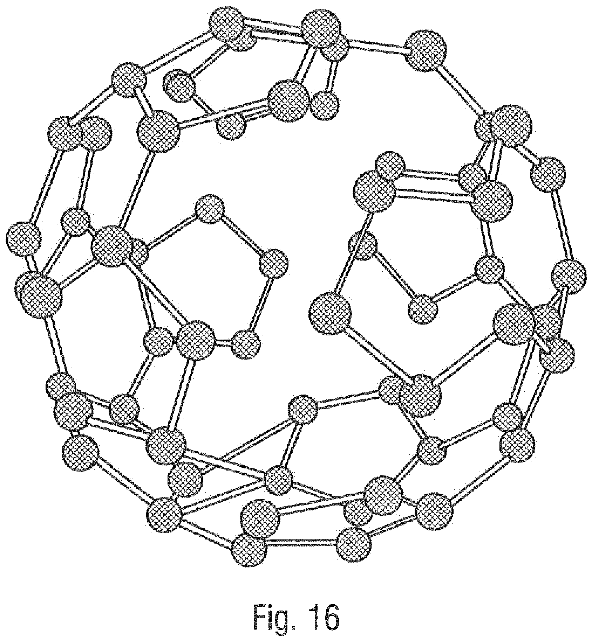

Fig. 16 shows an arrangement of probes in a truncated icosahedron, commonly known as a Buckyball [7]. The arrangement shown is especially beneficial as it allows for a small number of probes, while still covering a large area around a device under test. In other words, Fig. 16 shows a truncated icosahedron, which offers one form of geometric realization for an antenna measurement system comprised of signal conditioning units at each vertex end (node) and with no moving parts.

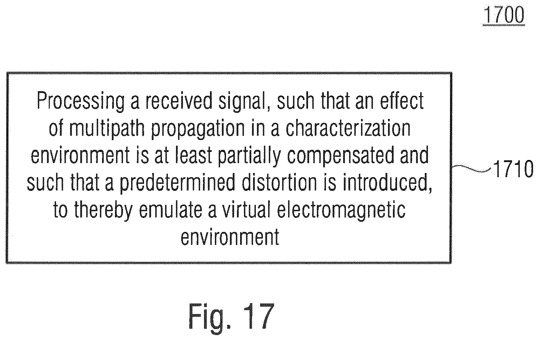

Fig. 17 shows a flow chart of a method 1700 for characterizing a wireless communication component, according to embodiments of the first aspect of the invention. The method comprises processing 1710 a received signal, such that an effect of multipath propagation in a characterization environment is at least partially compensated and such that a predetermined distortion is introduced, to thereby emulate a virtual electromagnetic environment.

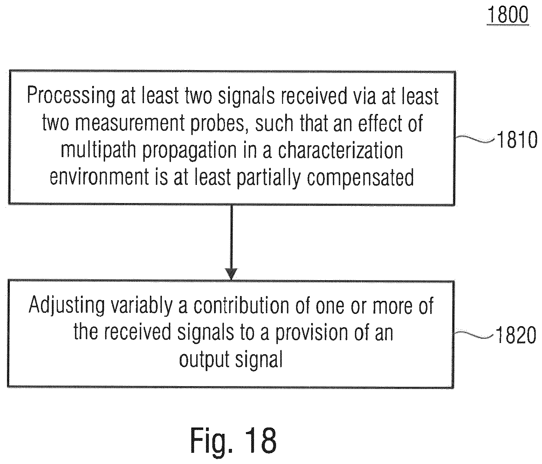

Fig. 18 shows a flow chart of a method 1800 for characterizing a wireless communication component, according to embodiments of the second aspect of the invention. The method comprises processing 1810 at least two signals received via at least two measurement probes, such that an effect of multipath propagation in a characterization environment is at least partially compensated. Further, the method comprises adjusting 1820 variably a contribution of one or more of the received signals to a provision of an output signal.

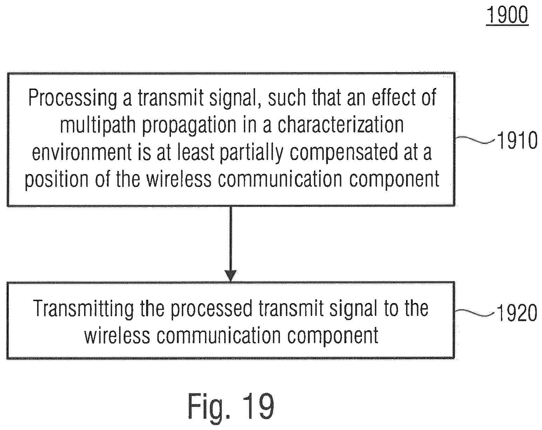

Fig. 19 shows a flow chart of a method 1900 for characterizing a wireless communication, according to embodiments of the third aspect of the invention. The method 1900 comprises processing 1910 a transmit signal, such that an effect of multipath propagation in a characterization environment is at least partially compensated at a position of the wireless communication component. Further, the method 1900 comprises transmitting 1920 the processed transmit signal to the wireless communication component.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitionary.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

### Further Aspects

In the following additional features will be described which can be optionally included in any of the above described embodiments.

In some cases, the proposed solution removes the requirement for an anechoic chamber by using electronic methods to reduce the effects of multipath propagation that would otherwise distort the signals being measured. Furthermore, the electronic hardware is configurable through software control to provide a virtual electromagnetic environment (VEE) [3] that can emulate a wide variety of propagation landscapes. A variety of VEEs are conceivable, ranging from the simple single user, interference-free, line-of-sight channel to complex interference scenarios in which several dimensions - such as frequency, time, direction (space), and polarization - are required to operate dynamically and in a multiuser configuration.

The characterization of multipath channels is extensively documented [4]. In general, practical multipath channels have statistics that can be assumed to be stationary over short periods of time and although not stationary in the strict statistical sense, these can be termed as wide-sense stationary (WSS). Many practical channels also have the property that contributions from different scatterers (with different time delays) are uncorrelated, and these are termed uncorrelated scattering (US) channels. It can be shown that WSS and US channels are time-frequency duals. In fact, many radio propagation channels fall into a class known as wide-sense stationary uncorrelated scattering (WSSUS) channels, which simultaneously exhibit wide-sense stationarity in the time variable and uncorrelated scattering in the time-delay variable. The channel in an outdoor range or a non-ideal anechoic chamber is likely to exhibit WSSUS characteristics although if such systems are well designed, the contributions from extraneous sources will be relatively small.

In Figs. 4A, 4B and 4C, three radio communication propagation environments are shown. Each is comprised of one or more base stations, a mobile terminal, scatterers and blockers. In Fig. 4A, the mobile terminal is considered to be a hand-portable device, depicted as a smartphone, and is carried by a pedestrian user moving at a relatively slow speed. Vehicular-mounted equipment, shown in Fig. 4B and installed in a passenger car, will move somewhat faster. A high-speed train scenario, presented in Fig. 4C, is likely to experience speeds in excess of the two previous use cases. Common to all environments is the existence of multiple base stations and mobile terminals, some of which will provide "wanted" communication signal whereas others can be considered as sources of interference that create "unwanted" signals. In addition, Figs. 4A, 4B and 4C depict a multipath propagation environment in which the wanted signal travels on radio waves via both line-of-sight (LOS) and non-line-of-sight (NLOS) paths. Typically, it is necessary to determine the performance of the radio communications system in scenarios such as those illustrated in the figure and practical, reliable and economic measurement systems and methods are therefore sought. As suggested by the colored circle in Figs. 4A, 4B and 4C, a system comprised of an arrangement of multiple antenna probes provides a potential solution to this challenge.

In embodiments, in order to create an OTA-in-VEE (Over-the-Air in Virtual Electromagnetic Environment) system, a multiprobe configuration is proposed in which the number of probes and their arrangement is based on factors that include the dimensions of the device under test (DUT), the required spatial sampling resolution and the frequency of operation. Such a system is enclosed within a non-anechoic chamber as shown in Figs. 5A and 5B in which the radiation absorbing material (RAM) has been removed and its function has been replaced by signal processing electronics. The latter can be realized in the form of a signal conditioning unit (SCU) for each probe that comprises the multiprobe system. These can be arranged for reciprocal reception and transmission - also denoted by uplink and downlink in Fig. 5A and Fig. 5B, respectively. The figures show the use of an optional shielded room which offers improved electromagnetic compatibility and susceptibility to and from other equipment. Signal processing techniques can, however, achieve similar benefits.

Virtual electromagnetic environments and acoustical wave field synthesis share an important similarity. In the latter, a virtual acoustic reality is created in which the spatial location (position) and character of sound sources can be created as can also the acoustic properties of the room. In a well-designed system, a human listener cannot identify whether the soundscape is real or artificial. Acoustic perception is, however, a subjective experience, whereas in electromagnetics, an objective evaluation of the environment is required.

Fig. 6 and Fig. 7 introduce the concept of applying equalization to the uplink and pre-distortion to the downlink, respectively, in which the effects of multipath are compensated by using a system which, in essence, may be an inverse filter for the channel. Although Figs. 6-7 depict implementation at radio frequencies, the techniques also find application at intermediate frequencies and in the baseband or time-sampled signal domain. The latter is afforded through the use of digital signal processing (DSP) techniques.

The most explicit form of equalizer, which may be part of 110, 220a, 220b or 310, is the tapped delay-line (TDL) filter which has the structure shown in Fig. 8. The similarity to a tapped delay line is obvious and the TDL equalizer is therefore, in many senses, a basic or generic equalizer. If the tap delays are judiciously chosen to correspond to the major delayed paths encountered in the multipath environment and the tap weights w₀, w₁, ...,w_{N} are suitably adjusted, the TDL equalizer is essentially a matched filter [5]. The structure shown in Fig. 8 has N delay elements, N+1 taps, and N+1 complex weighting elements; these can be set, and if necessary updated from time to time. It would be common practice to use an algorithm such as the least-mean square (LMS) algorithm, and an iterative convergent process, to establish the optimum tap weights.

The TDL equalizer is an example of a linear filter arranged to separate the superimposed components caused by multipath echoes, weight them suitably and then add them together in a constructive manner. To perform effectively, this type of equalizer may, as indicated above, behave as an inverse filter of the channel; hence, in a frequency-selective channel, the equalizer amplifies the weak spectral components and attenuates the strong ones in order to provide an overall flat frequency response and a linear phase response.

While reflections and diffractions might fulfil the WSSUS conditions, specific geometries and object sizes may cause frequency and polarization dependency in reflection and diffraction to be considered in the equalization and/or pre-distortion process. Therefore, in particular cases, frequency and polarization selective filter design should be incorporated where and when needed.

Furthermore, in the case of size/extension of the DUT across several wavelengths equalization and pre-distortion techniques have to be applied such that the entire area, sphere or volume of the antenna outer surface is pre- or post-compensated by the algorithm(s) applied. This might involve more sophisticated calibration beforehand and potentially more sensors and/or probes.

Very effective performance can be obtained from the TDL structure, which belongs to the class of linear equalizers. However, linear equalizers do not always perform well where there are deep spectral nulls in the channel characteristic or where there is severe distortion. In these cases, improved performance can be obtained using non-linear equalizers. Well-known types of non-linear equalizer include the decision-feedback equalizer (DFE) and the MLSE Viterbi equalizer.

The concept of the multiprobe antenna measurement, first shown in Figs. 5A and 5B, is now extended to a system designed to measure and test the performance of a combined antenna and radio system (CARS). Figs. 9A and 9B depict configurations for both uplink and downlink measurements of a CARS wherein its performance is assessed in a VEE. The latter is emulated through the use of a profiler and a fading module associated with each probe. In the uplink scenario, the profiler unites the outputs of the multiple fading units whereas in the downlink it separates them to produce multiple inputs. In both the uplink and downlink directions, the profiler has the means to apply amplitude and phase weighting thus allowing a DUT to be sensed or illuminated using specific spatial wave distributions. Both static and dynamic configurations can be realized. The operation of the profiler and fading units is orchestrated in such a way to create the required channel environment, propagation landscape or VEE.

It follows from the preceding discussion that uplink measurements of a CARS can be made in a non-echoic environment by blending together the virtues of the equalization, e.g., performed by block 110, 210a or 210b, technique and the VEE emulation method, e.g., performed by block 120 or 230. Similarly, in the downlink, the operation of the pre-distorter, e.g. block 310, and the VEE emulation are amalgamated as shown in Figs. 10A and 10B.

In Figs. 10A and 10B, the uplink shows an equalizer (one of blocks 1040) associated with each probe, immediately followed by a fading module. The profiler takes the output of each fading module and produces one output which is then used in the measurement system. Similarly but in reverse, the downlink section of Figs. 10A and 10B shows a single input profiler whose multiple outputs are immediately connected to fading modules and a pre-distorter associated with each probe. A rearrangement of the signal processing blocks allows the function of the profiler to be distributed to each probe as shown in Figs. 11A and 11B. This reorganization is shown as an example of an alternative form of implementation only, thus having no effect on the function of the system.

The equalization and pre-distortion concepts can now be applied to the OTA-in-VEE as illustrated in Figs. 12A and 12B in which an SCU, comprised of an equalizer in the uplink or a pre-distorter in the downlink, a fading module and a profiler, is shown. The operation of the profiler and the fading module, regardless of their use in either uplink or downlink measurement scenarios, is orchestrated in such a way to achieve the required VEE.

With reference to the propagation environments presented in Figs. 4A, 4B and 4C, the arrangement of Fig. 12B is now extended to provide the means necessary to create a VEE comprised of both wanted and interfering signals. For example, Fig. 13, and without loss of generality, the signal labelled "RF input 1" represents the wanted signal while the other signals are considered to be sources of interference. For carrier aggregation scenarios, a plurality of component carriers could be associated with multiple "RF input" signal lines, still allowing interfering signals to be routed through other available RF inputs. Here, the profiler thereby accepts both wanted and unwanted signals, and distributes them to the various fading modules and pre-distorters, thus allowing the performance of the DUT to be measured in the presence of interference.

Before using the system for measurement, an initial calibration may be performed in which the effects of multipath propagation present in the channel between the DUT and each probe are reduced to the required level. In certain implementations, system calibration is made using reference signals or waveforms that are built into the DUT and for which the equalizer has an a priori knowledge. The channel's reciprocity allows similar coefficients to be applied to both the equalizer and the pre-distorter associated with each probe.

In the uplink, the profiler combines the signals received from multiple probes whereas in the downlink, it distributes signals to multiple probes for transmission. Together with the fading module, these units create the required propagation landscape or VEE.

Regardless of their individual implementation in hardware, software or combinations of the two, the signal processing functions that comprise the signal conditioning unit can be merged jointly or in part. For example, the operation of the profiler and fading module could be combined into one functional block leaving the equalizer or pre-distorter as an independent unit. Alternatively, all three functions could be combined into one unit. Furthermore, and through the use of bidirectional signal flow, the SCU can be dynamically configured for either uplink or downlink operation and for the simultaneous operation of both uplink and downlink operation together. The system also provides the means to measure the performance of the DUT in environments with and without interference. The melding of the foregoing features allows the generalized configuration shown in Fig. 14 to be realized.

When measurement probes are arranged in two dimensions - such as a circle, semicircle, arc or line - rotation of the DUT about its axis may be helpful to perform measurements over a full sphere or hemisphere of space as shown in Fig. 15.

An alternative arrangement, for which no mechanical rotation of the DUT is needed - and thus offers a considerable improvement in measurement speed - is shown in Fig. 16. Here the measurement probes are positioned at the (sixty) vertices of a truncated icosahedron ("Buckyball") [7]. This offers the geometrical property of equidistant probe spacing over the surface of an imaginary sphere. In practice, an SCU would be associated with either the full set or a subset of the sixty probes.

The probes/sensors distributed equidistantly on the sphere should be built such they allow/support polarization resolving probing/sensing in order to cover polarization effects/properties of the antennas under test (DUT).

It is also proposed that each vertex contains optical-to-electrical and electrical-to-optical converters, thus removing the need for electrical cable connections to the measurement probes and thereby reducing the effect of the structure on the radiation of the DUT. In applications requiring enhanced spatial sampling, mechanical rotation or translation of either the probe assembly, the DUT or combinations of the two are proposed.

Embodiments of the invention disclosed herein offer a new method of performing combined antenna and radio system measurements in non-anechoic environments. This is facilitated through the use of a variety signal processing techniques that include distribution, combination, modulation and equalization. Equalization, which forms a beneficial part of this invention, is a signal processing technique used in both wired and wireless systems, and one that reduces the effects of signal distortion commonly encountered in multipath channels and environments.

In general, signal processing techniques-which can be implemented in hardware, software or hybrid combinations of the two-provide the means needed to create flexible measurement systems that are easily configurable and can be dynamically adapted to environmental changes.

Advantages of the present invention are:
The aforementioned combination of signal processing techniques, including the beneficial use of equalization, removes the need for an anechoic chamber. This allows flexible, adaptable and dynamic test and measurement systems to be constructed that offer both improved measurement speed and measurement throughput.

Traditionally, antenna radiation pattern measurements are made in anechoic chambers. However, even the most carefully-designed anechoic chambers are non-ideal and do not eliminate all reflections or echoes. Both anechoic chambers and reverberation chambers can be extended to the OTA measurement of combined antenna and radio communication systems.

Embodiments of the invention introduce the concept of both the measurement system and the DUT having a priori knowledge of the test signal or waveform used for equalization and measurement purposes. This also implies the awareness of certain signalling patterns or control information.

In general, embodiments describe a combined antenna and radio measurement system designed for non-anechoic environments.

### References

[1] 3GPP TS37.320, Radio Measurement collection for minimization of drive test (MDT)*.*
[2] 3GPP TR 37.977, Verification of radiated multi-antenna reception performance of User Equipment (UE), V14.1.0, 2016-09.
[3] R. K. Sharma, W. Kotterman, M. H. Landman and et al., "Over-the-Air Testing of Cognitive Radio Nodes in a Virtual Electromagnetic Environment," International Journal of Antennas and Propagation, vol. vol. 2013, no. Article ID 945283, pp. 1-16, 2013.
[4] J. D. Parsons, The Mobile Radio Propagation Channel, 2nd ed., Chichester, West Sussex: John Wiley & Sons Ltd., 2000.
[5] R. W. Lucky, J. Salz and E. J. Weldon, Principles of Data Communication. McGraw-Hill, New York, NY, USA, 1968.
[6] P. S. H. Leather and J. D. Parsons, "Antenna measurement systems". US Patent 2006/0055592 A1, 16th March 2006.
[7] P.S.H. Leather, J.D. Parsons, 'Equalization for antenna pattern measurements: established technique - new application', IEEE Antennas Propag. Mag., 2003, 45, (2), pp. 154-161

## Claims

1. An apparatus (100; 1000; 1100) for characterizing a wireless communication component (905),
wherein the apparatus is configured to process a received signal (102), such that an effect of multipath propagation in a characterization environment is at least partially compensated, and such that a predetermined distortion is introduced, to thereby emulate a virtual electromagnetic environment;
wherein the apparatus is configured to apply a time-invariant filtering to introduce a static filtering contribution, to at least partially compensate an effect of multipath propagation, and wherein the apparatus is configured to apply a time-variant filtering contribution to introduce the predetermined distortion.

2. An apparatus (100; 1000; 1100) for characterizing a wireless communication component (905),
wherein the apparatus is configured to process a received signal (102), such that an effect of multipath propagation in a characterization environment is at least partially compensated, and such that a predetermined distortion is introduced, to thereby emulate a virtual electromagnetic environment;
wherein the apparatus is configured to apply an equalization, which behaves as an inverse filter of a channel, and in which the effect of multipath propagation is at least partially compensated, and
wherein the apparatus is configured to introduce the predetermined distortion by weighting spectral values of the received signal with predetermined fading coefficients.

3. An apparatus (100; 1000; 1100) for characterizing a wireless communication component (905),
wherein the apparatus is configured to process a received signal (102), such that an effect of multipath propagation in a characterization environment is at least partially compensated, and such that a predetermined distortion is introduced, to thereby emulate a virtual electromagnetic environment;
wherein the apparatus is configured to apply an equalization, which behaves as an inverse filter of a channel, and in which the effect of multipath propagation is at least partially compensated, and
wherein the apparatus is configured to convolve the received signal with a predetermined impulse response, such that the convolution achieves the predetermined distortion.

4. An apparatus (100; 1000; 1100) for characterizing a wireless communication component (905),
wherein the apparatus is configured to process a received signal (102), such that an effect of multipath propagation in a characterization environment is at least partially compensated, and such that a predetermined distortion is introduced, to thereby emulate a virtual electromagnetic environment;
wherein the apparatus is configured to obtain a filter, by using a reception of a reference signal, and wherein the apparatus is configured to use the obtained filter to at least partially compensate the effect of multipath propagation of the characterization environment;
wherein the apparatus is configured to apply a time-variant filtering contribution to introduce the predetermined distortion, or
wherein the apparatus is configured to introduce the predetermined distortion by weighting spectral values of the received signal with predetermined fading coefficients, or
wherein the apparatus is configured to convolve the received signal with a predetermined impulse response, such that the convolution achieves the predetermined distortion, or
wherein the apparatus comprises a plurality of probes (910) configured to obtain a plurality of received signals, and wherein the apparatus is configured to allow for a variable adjustment of a contribution of one or more of the received signals to a provision of an output signal, to thereby emulate a virtual electromagnetic environment.

5. An apparatus (100; 1000; 1100) for characterizing a wireless communication component (905),
wherein the apparatus is configured to process a received signal (102), such that an effect of multipath propagation in a characterization environment is at least partially compensated, and such that a predetermined distortion is introduced, to thereby emulate a virtual electromagnetic environment;
wherein the apparatus comprises a plurality of probes (910) configured to obtain a plurality of received signals, and
wherein the apparatus is configured to apply an equalization, which behaves as an inverse filter of a channel, and in which the effect of multipath propagation is at least partially compensated, and
wherein the apparatus is configured to allow for a variable adjustment of a contribution of one or more of the received signals to a provision of an output signal, to thereby emulate a virtual electromagnetic environment.

6. An apparatus according to claim 5, wherein the apparatus is configured to variably adjust the contribution of one or more of the received signals in a time-varying manner.

7. An apparatus according to claim 5 or 6, wherein the apparatus is configured to emulate a motion of the wireless communication component by varying the contribution of one or more of the received signals to the output signal.

8. An apparatus according to one of the claims 5 to 7, wherein the apparatus is configured to variably adjust a contribution of one or more of the received signals by weighting and combining two or more of the received signals.

9. An apparatus according to claim 8, wherein the apparatus is configured to adjust the weighting such that a beamforming is obtained, in order to variably adjust a contribution of one or more of the received signals.

10. An apparatus according to claim 9, wherein the apparatus is configured to individually filter at least one of the at least two received signals and to consequently combine the at least two received signals to obtain the output signal, such that the output signal provides for a spatial selectivity.

11. An apparatus according to one of the claims 1 to 10, wherein the apparatus is configured to introduce the predetermined distortion, such that a fading of a mobile channel between the wireless component and the apparatus is emulated.

12. An apparatus according to one of the claims 1 to 11, wherein the apparatus is configured to introduce the predetermined distortion, such that the apparatus emulates a motion of the wireless communication component.

13. An apparatus according to one of the claims 1 to 12, wherein the apparatus is configured to introduce the predetermined distortion, such that the apparatus emulates a desired multipath propagation.

14. An apparatus according to one of the claims 1 to 13, wherein the apparatus is configured to obtain information about a desired electromagnetic environment through an interface, and wherein the apparatus is configured to adjust the predetermined distortion according to the information about the desired electromagnetic environment and/or to set a variable adjustment of a contribution of one or more received signals according to the information about the desired electromagnetic environment.

15. An apparatus according to one of the claims 1 to 14, wherein the apparatus comprises a filter which is configured to at least partially compensate a multipath propagation in a characterization environment and/or to introduce a predetermined distortion and/or to allow for a variable adjustment of a contribution of one or more received signals.

16. A measurement system (1000; 1100) comprising
an apparatus according to one of the claims 1 to 15,
wherein the apparatus is arranged in a non-anechoic chamber.

17. A measurement system according to claim 16, wherein the system comprises an evaluator, and wherein the evaluator is configured to evaluate a link performance between the one or more apparatuses and the wireless communication component.

18. A measurement system according to claim 17, wherein the evaluator is configured to evaluate the link performance in the presence of emulated fading.

19. A measurement system according to claim 17 or 18, wherein the evaluator is configured to evaluate the link performance in presence of emulated motion.

20. Method (1700) for characterizing a wireless communication component comprising,
processing (1710) a received signal, such that an effect of multipath propagation in a characterization environment is at least partially compensated and such that a predetermined distortion is introduced, to thereby emulate a virtual electromagnetic environment;
wherein the method comprises applying a time-invariant filtering to introduce a static filtering contribution, to at least partially compensate an effect of multipath propagation, and wherein the apparatus is configured to apply a time-variant filtering contribution to introduce the predetermined distortion.

21. Method (1700) for characterizing a wireless communication component comprising,
processing (1710) a received signal, such that an effect of multipath propagation in a characterization environment is at least partially compensated and such that a predetermined distortion is introduced, to thereby emulate a virtual electromagnetic environment;
wherein the method comprises applying an equalization, which behaves as an inverse filter of a channel, and in which the effect of multipath propagation is at least partially compensated, and
wherein the method comprises introducing the predetermined distortion by weighting spectral values of the received signal with predetermined fading coefficients.

22. Method (1700) for characterizing a wireless communication component comprising,
processing (1710) a received signal, such that an effect of multipath propagation in a characterization environment is at least partially compensated and such that a predetermined distortion is introduced, to thereby emulate a virtual electromagnetic environment;
wherein the method comprises applying an equalization, which behaves as an inverse filter of a channel, and in which the effect of multipath propagation is at least partially compensated, and
wherein the method comprises convolving the received signal with a predetermined impulse response, such that the convolution achieves the predetermined distortion.

23. Method (1700) for characterizing a wireless communication component comprising,
processing (1710) a received signal, such that an effect of multipath propagation in a characterization environment is at least partially compensated and such that a predetermined distortion is introduced, to thereby emulate a virtual electromagnetic environment;
wherein the method comprises obtaining a filter, by using a reception of a reference signal, and wherein the method comprises using the obtained filter to at least partially compensate the effect of multipath propagation of the characterization environment;
wherein the method comprises applying a time-variant filtering contribution to introduce the predetermined distortion, or
wherein the method comprises introducing the predetermined distortion by weighting spectral values of the received signal with predetermined fading coefficients, or
wherein the method comprises convolving the received signal with a predetermined impulse response, such that the convolution achieves the predetermined distortion, or
wherein the method comprises, by a plurality of probes (910) configured to obtain a plurality of received signals, allowing for a variable adjustment of a contribution of one or more of the received signals to a provision of an output signal, to thereby emulate a virtual electromagnetic environment.

24. Method (1700) for characterizing a wireless communication component comprising,
processing (1710) a received signal, such that an effect of multipath propagation in a characterization environment is at least partially compensated and such that a predetermined distortion is introduced, to thereby emulate a virtual electromagnetic environment;
wherein the method comprises applying an equalization, which behaves as an inverse filter of a channel, and in which the effect of multipath propagation is at least partially compensated, and
wherein the method comprises performing a variable adjustment of a contribution of one or more received signals, obtained using a plurality of probes, to a provision of an output signal, to thereby emulate a virtual electromagnetic environment.

25. Computer program with a program code for performing one of the methods according to claims 20 to 24, when the computer program runs on a computer or a microcontroller.

## Patentansprüche

1. Eine Vorrichtung (100; 1000; 1100) zum Charakterisieren einer Drahtloskommunikationskomponente (905),
wobei die Vorrichtung dazu ausgebildet ist, ein empfangenes Signal (102) derart zu verarbeiten, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei die Vorrichtung dazu ausgebildet ist, ein zeitinvariantes Filtern anzuwenden, um einen statischen Filterungsbeitrag einzuführen, um einen Effekt einer Mehrwegeausbreitung zumindest teilweise zu kompensieren, und wobei die Vorrichtung dazu ausgebildet ist, einen zeitvarianten Filterungsbeitrag anzuwenden, um die vorbestimmte Verzerrung einzuführen.

2. Eine Vorrichtung (100; 1000; 1100) zum Charakterisieren einer Drahtloskommunikationskomponente (905),
wobei die Vorrichtung dazu ausgebildet ist, ein empfangenes Signal (102) derart zu verarbeiten, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei die Vorrichtung dazu ausgebildet ist, eine Entzerrung anzuwenden, die sich wie ein Inversfilter eines Kanals verhält, und bei der der Effekt einer Mehrwegeausbreitung zumindest teilweise kompensiert wird, und
wobei die Vorrichtung dazu ausgebildet ist, die vorbestimmte Verzerrung einzuführen durch Gewichten von Spektralwerten des empfangenen Signals mit vorbestimmten Abklingkoeffizienten.

3. Eine Vorrichtung (100; 1000; 1100) zum Charakterisieren einer Drahtloskommunikationskomponente (905),
wobei die Vorrichtung dazu ausgebildet ist, ein empfangenes Signal (102) derart zu verarbeiten, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei die Vorrichtung dazu ausgebildet ist, eine Entzerrung anzuwenden, die sich wie ein Inversfilter eines Kanals verhält, und bei der der Effekt einer Mehrwegeausbreitung zumindest teilweise kompensiert wird, und
wobei die Vorrichtung dazu ausgebildet ist, das empfangene Signal mit einer vorbestimmten Impulsantwort zu falten, derart, dass die Faltung die vorbestimmte Verzerrung erzielt.

4. Eine Vorrichtung (100; 1000; 1100) zum Charakterisieren einer Drahtloskommunikationskomponente (905),
wobei die Vorrichtung dazu ausgebildet ist, ein empfangenes Signal (102) derart zu verarbeiten, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei die Vorrichtung dazu ausgebildet ist, ein Filter zu erhalten durch Verwenden eines Empfangs eines Referenzsignals, und wobei die Vorrichtung dazu ausgebildet ist, das erhaltene Filter zu verwenden, um den Effekt einer Mehrwegeausbreitung der Charakterisierungsumgebung zumindest teilweise zu kompensieren;
wobei die Vorrichtung dazu ausgebildet ist, einen zeitvarianten Filterungsbeitrag anzuwenden, um die vorbestimmte Verzerrung einzuführen, oder
wobei die Vorrichtung dazu ausgebildet ist, die vorbestimmte Verzerrung einzuführen durch Gewichten von Spektralwerten des empfangenen Signals mit vorbestimmten Abklingkoeffizienten, oder
wobei die Vorrichtung dazu ausgebildet ist, das empfangene Signal mit einer vorbestimmten Impulsantwort zu falten, derart, dass die Faltung die vorbestimmte Verzerrung erzielt, oder
wobei die Vorrichtung eine Mehrzahl von Sonden (910) aufweist, die dazu ausgebildet sind, eine Mehrzahl empfangener Signale zu erhalten, und wobei die Vorrichtung dazu ausgebildet ist, eine variable Anpassung eines Beitrags von einem oder mehr der empfangenen Signale zu einer Bereitstellung eines Ausgangssignals zu erlauben, um dadurch eine virtuelle elektromagnetische Umgebung zu emulieren.

5. Eine Vorrichtung (100; 1000; 1100) zum Charakterisieren einer Drahtloskommunikationskomponente (905),
wobei die Vorrichtung dazu ausgebildet ist, ein empfangenes Signal (102) derart zu verarbeiten, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei die Vorrichtung eine Mehrzahl von Sonden (910) aufweist, die dazu ausgebildet sind, eine Mehrzahl empfangener Signale zu erhalten, und
wobei die Vorrichtung dazu ausgebildet ist, eine Entzerrung anzuwenden, die sich wie ein Inversfilter eines Kanals verhält, und bei der der Effekt der Mehrwegeausbreitung zumindest teilweise kompensiert wird, und
wobei die Vorrichtung dazu ausgebildet ist, eine variable Anpassung eines Beitrags von einem oder mehr der empfangenen Signale zu einer Bereitstellung eines Ausgangssignals zu erlauben, um dadurch eine virtuelle elektromagnetische Umgebung zu emulieren.

6. Eine Vorrichtung gemäß Anspruch 5, wobei die Vorrichtung dazu ausgebildet ist, den Beitrag von einem oder mehr der empfangenen Signale in einer zeitlich veränderlichen Weise variabel anzupassen.

7. Eine Vorrichtung gemäß Anspruch 5 oder 6, wobei die Vorrichtung dazu ausgebildet ist, eine Bewegung der Drahtloskommunikationskomponente zu emulieren durch Variieren des Beitrags von einem oder mehr der empfangenen Signale zu dem Ausgangssignal.

8. Eine Vorrichtung gemäß einem der Ansprüche 5 bis 7, wobei die Vorrichtung dazu ausgebildet ist, einen Beitrag von einem oder mehr der empfangenen Signale variabel anzupassen durch Gewichtung und Kombinieren von zwei oder mehr der empfangenen Signale.

9. Eine Vorrichtung gemäß Anspruch 8, wobei die Vorrichtung dazu ausgebildet ist, die Gewichtung derart anzupassen, dass ein Strahlformen erhalten wird, um einen Beitrag von einem oder mehr der empfangenen Signale variabel anzupassen.

10. Eine Vorrichtung gemäß Anspruch 9, wobei die Vorrichtung dazu ausgebildet ist, zumindest eines der zumindest zwei empfangenen Signale individuell zu filtern und in der Folge die zumindest zwei empfangenen Signale zu kombinieren, um das Ausgangssignal zu erhalten, derart, dass das Ausgangssignal für eine räumliche Selektivität sorgt.

11. Eine Vorrichtung gemäß einem der Ansprüche 1 bis 10, wobei die Vorrichtung dazu ausgebildet ist, die vorbestimmte Verzerrung derart einzuführen, dass ein Abklingen eines Mobilkanals zwischen der Drahtloskomponente und der Vorrichtung emuliert wird.

12. Eine Vorrichtung gemäß einem der Ansprüche 1 bis 11, wobei die Vorrichtung dazu ausgebildet ist, die vorbestimmte Verzerrung derart einzuführen, dass die Vorrichtung eine Bewegung der Drahtloskommunikationskomponente emuliert.

13. Eine Vorrichtung gemäß einem der Ansprüche 1 bis 12, wobei die Vorrichtung dazu ausgebildet ist, die vorbestimmte Verzerrung derart einzuführen, dass die Vorrichtung eine erwünschte Mehrwegeausbreitung emuliert.

14. Eine Vorrichtung gemäß einem der Ansprüche 1 bis 13, wobei die Vorrichtung dazu ausgebildet ist, Informationen über eine erwünschte elektromagnetische Umgebung durch eine Schnittstelle zu erhalten, und wobei die Vorrichtung dazu ausgebildet ist, die vorbestimmte Verzerrung gemäß der Information über die erwünschte elektromagnetische Umgebung anzupassen und/oder eine variable Anpassung eines Beitrags von einem oder mehr empfangenen Signalen gemäß den Informationen über die erwünschte elektromagnetische Umgebung einzustellen.

15. Eine Vorrichtung gemäß einem der Ansprüche 1 bis 14, wobei die Vorrichtung ein Filter aufweist, das dazu ausgebildet ist, eine Mehrwegeausbreitung in einer Charakterisierungsumgebung zumindest teilweise zu kompensieren und/oder eine vorbestimmte Verzerrung einzuführen und/oder eine variable Anpassung eines Beitrags von einem oder mehr empfangenen Signalen zu erlauben.

16. Ein Messsystem (1000;1100), das folgendes Merkmal aufweist:
eine Vorrichtung gemäß einem der Ansprüche 1 bis 15,
wobei die Vorrichtung in einem nichtschalltoten Raum angeordnet ist.

17. Ein Messsystem gemäß Anspruch 16, wobei das System einen Auswerter aufweist, und wobei der Auswerter dazu ausgebildet ist, ein Bindungsverhalten zwischen der einen oder den mehr Vorrichtungen und der Drahtloskommunikationskomponente auszuwerten.

18. Ein Messsystem gemäß Anspruch 17, bei dem der Auswerter dazu ausgebildet ist, das Bindungsverhalten bei Vorliegen eines emulierten Abklingens auszuwerten.

19. Ein Messsystem gemäß Anspruch 17 oder 18, bei dem der Auswerter dazu ausgebildet ist, das Bindungsverhalten bei Vorliegen einer emulierten Bewegung auszuwerten.

20. Verfahren (1700) zum Charakterisieren einer Drahtloskommunikationskomponente, das folgenden Schritt aufweist:
Verarbeiten (1710) eines empfangenen Signals derart, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei das Verfahren ein Anwenden eines zeitinvarianten Filterns aufweist, um einen statischen Filterungsbeitrag einzuführen, um einen Effekt einer Mehrwegeausbreitung zumindest teilweise zu kompensieren, und wobei die Vorrichtung dazu ausgebildet ist, einen zeitvarianten Filterungsbeitrag anzuwenden, um die vorbestimmte Verzerrung einzuführen.

21. Verfahren (1700) zum Charakterisieren einer Drahtloskommunikationskomponente, das folgenden Schritt aufweist:
Verarbeiten (1710) eines empfangenen Signals derart, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei das Verfahren ein Anwenden einer Entzerrung aufweist, die sich wie ein Inversfilter eines Kanals verhält, und bei der der Effekt einer Mehrwegeausbreitung zumindest teilweise kompensiert wird, und
wobei das Verfahren ein Einführen der vorbestimmten Verzerrung durch Gewichten von Spektralwerten des empfangenen Signals mit vorbestimmten Abklingkoeffizienten aufweist.

22. Verfahren (1700) zum Charakterisieren einer Drahtloskommunikationskomponente, das folgenden Schritt aufweist:
Verarbeiten (1710) eines empfangenen Signals derart, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei das Verfahren ein Anwenden einer Entzerrung aufweist, die sich wie ein Inversfilter eines Kanals verhält, und bei der der Effekt einer Mehrwegeausbreitung zumindest teilweise kompensiert wird, und
wobei das Verfahren ein Falten des empfangenen Signals mit einer vorbestimmten Impulsantwort aufweist derart, dass die Faltung die vorbestimmte Verzerrung erzielt.

23. Verfahren (1700) zum Charakterisieren einer Drahtloskommunikationskomponente, das folgenden Schritt aufweist:
Verarbeiten (1710) eines empfangenen Signals derart, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei das Verfahren ein Erhalten eines Filters durch Verwenden eines Empfangs eines Referenzsignals aufweist, und wobei das Verfahren ein Verwenden des erhaltenen Filters aufweist, um den Effekt einer Mehrwegeausbreitung der Charakterisierungsumgebung zumindest teilweise zu kompensieren;
wobei das Verfahren ein Anwenden eines zeitvarianten Filterungsbeitrags aufweist, um die vorbestimmte Verzerrung einzuführen, oder
wobei das Verfahren ein Einführen der vorbestimmten Verzerrung durch Gewichten von Spektralwerten des empfangenen Signals mit vorbestimmten Abklingkoeffizienten aufweist, oder
wobei das Verfahren ein Falten des empfangenen Signals mit einer vorbestimmten Impulsantwort aufweist, derart, dass die Faltung die vorbestimmte Verzerrung erzielt, oder
wobei das Verfahren, durch eine Mehrzahl von Sonden (910), die dazu ausgebildet sind, eine Mehrzahl empfangener Signale zu erhalten, ein Erlauben einer variablen Anpassung eines Beitrags von einem oder mehr der empfangenen Signale zu einer Bereitstellung eines Ausgangssignals aufweist, um dadurch eine virtuelle elektromagnetische Umgebung zu emulieren.

24. Verfahren (1700) zum Charakterisieren einer Drahtloskommunikationskomponente, das folgenden Schritt aufweist:
Verarbeiten (1710) eines empfangenen Signals derart, dass ein Effekt einer Mehrwegeausbreitung in einer Charakterisierungsumgebung zumindest teilweise kompensiert wird, und derart, dass eine vorbestimmte Verzerrung eingeführt wird, um dadurch eine virtuelle elektromagnetische Umgebung zu emulieren;
wobei das Verfahren ein Anwenden einer Entzerrung aufweist, die sich wie ein Inversfilter eines Kanals verhält, und bei der der Effekt der Mehrwegeausbreitung zumindest teilweise kompensiert wird, und
wobei das Verfahren ein Durchführen einer variablen Anpassung eines Beitrags von einem oder mehr empfangenen Signalen, die unter Verwendung einer Mehrzahl von Sonden erhalten werden, zu einer Bereitstellung eines Ausgangssignals aufweist, um dadurch eine virtuelle elektromagnetische Umgebung zu emulieren.

25. Computerprogramm mit einem Programmcode zum Durchführen eines der Verfahren gemäß den Ansprüchen 20 bis 24, wenn das Computerprogramm auf einem Computer oder einer Mikrosteuerung abläuft.

## Revendications

1. Appareil (100; 1000; 1100) pour caractériser un élément de communication sans fil (905),
dans lequel l'appareil est configuré pour traiter un signal reçu (102) de sorte que soit compensé au moins partiellement un effet de propagation par trajets multiples dans un environnement de caractérisation, et de sorte que soit introduite une distorsion prédéterminée pour émuler ainsi un environnement électromagnétique virtuel;
dans lequel l'appareil est configuré pour appliquer un filtrage invariable dans le temps pour introduire une contribution de filtrage statique pour compenser au moins partiellement un effet de propagation par trajets multiples, et dans lequel l'appareil est configuré pour appliquer une contribution de filtrage variable dans le temps pour introduire la distorsion prédéterminée.

2. Appareil (100; 1000; 1100) pour caractériser un élément de communication sans fil (905),
dans lequel l'appareil est configuré pour traiter un signal reçu (102) de sorte que soit compensé au moins partiellement un effet de propagation par trajets multiples dans un environnement de caractérisation, et de sorte que soit introduite une distorsion prédéterminée pour émuler ainsi un environnement électromagnétique virtuel;
dans lequel l'appareil est configuré pour appliquer une égalisation qui se comporte comme un filtre inverse d'un canal, et dans lequel est compensé au moins partiellement l'effet de propagation par trajets multiples, et
dans lequel l'appareil est configuré pour introduire la distorsion prédéterminée en pondérant les valeurs spectrales du signal reçu par des coefficients d'atténuation prédéterminés.

3. Appareil (100; 1000; 1100) pour caractériser un élément de communication sans fil (905),
dans lequel l'appareil est configuré pour traiter un signal reçu (102) de sorte que soit compensé au moins partiellement un effet de propagation par trajets multiples dans un environnement de caractérisation, et de sorte que soit introduite une distorsion prédéterminée pour émuler ainsi un environnement électromagnétique virtuel;
dans lequel l'appareil est configuré pour appliquer une égalisation qui se comporte comme un filtre inverse d'un canal, et dans lequel est compensé au moins partiellement l'effet de propagation par trajets multiples, et
dans lequel l'appareil est configuré pour effectuer une convolution du signal reçu par une réponse impulsionnelle prédéterminée, de sorte que la convolution atteigne la distorsion prédéterminée.

4. Appareil (100; 1000; 1100) pour caractériser un élément de communication sans fil (905),
dans lequel l'appareil est configuré pour traiter un signal reçu (102) de sorte que soit compensé au moins partiellement un effet de propagation par trajets multiples dans un environnement de caractérisation, et de sorte que soit introduite une distorsion prédéterminée pour émuler ainsi un environnement électromagnétique virtuel;
dans lequel l'appareil est configuré pour obtenir un filtre en utilisant une réception d'un signal de référence, et dans lequel l'appareil est configuré pour utiliser le filtre obtenu pour compenser au moins partiellement l'effet de la propagation par trajets multiples de l'environnement de caractérisation;
dans lequel l'appareil est configuré pour appliquer une contribution de filtrage variable dans le temps pour introduire la distorsion prédéterminée, ou
dans lequel l'appareil est configuré pour introduire la distorsion prédéterminée en pondérant les valeurs spectrales du signal reçu par des coefficients d'atténuation prédéterminés, ou
dans lequel l'appareil est configuré pour effectuer une convolution du signal reçu par une réponse impulsionnelle prédéterminée, de sorte que la convolution atteigne la distorsion prédéterminée, ou
dans lequel l'appareil comprend une pluralité de sondes (910) configurées pour obtenir une pluralité de signaux reçus, et dans lequel l'appareil est configuré pour permettre un ajustement variable d'une contribution d'un ou plusieurs des signaux reçus à une fourniture d'un signal de sortie pour émuler ainsi un environnement électromagnétique virtuel.

5. Appareil (100; 1000; 1100) pour caractériser un élément de communication sans fil (905),
dans lequel l'appareil est configuré pour traiter un signal reçu (102) de sorte que soit compensé au moins partiellement un effet de propagation par trajets multiples dans un environnement de caractérisation, et de sorte que soit introduite une distorsion prédéterminée pour émuler ainsi un environnement électromagnétique virtuel;
dans lequel l'appareil comprend une pluralité de sondes (910) configurées pour obtenir une pluralité de signaux reçus, et
dans lequel l'appareil est configuré pour appliquer une égalisation qui se comporte comme un filtre inverse d'un canal, et dans lequel est compensé au moins partiellement l'effet de propagation par trajets multiples, et
dans lequel l'appareil est configuré pour permettre un ajustement variable d'une contribution d'un ou plusieurs des signaux reçus à une fourniture d'un signal de sortie pour émuler ainsi un environnement électromagnétique virtuel.

6. Appareil selon la revendication 5, dans lequel l'appareil est configuré pour ajuster de manière variable la contribution d'un ou plusieurs des signaux reçus de manière variable dans le temps.

7. Appareil selon la revendication 5 ou 6, dans lequel l'appareil est configuré pour émuler un mouvement de l'élément de communication sans fil en faisant varier la contribution d'un ou plusieurs des signaux reçus au signal de sortie.

8. Appareil selon l'une des revendications 5 à 7, dans lequel l'appareil est configuré pour ajuster de manière variable une contribution d'un ou plusieurs des signaux reçus en pondérant et en combinant deux ou plusieurs des signaux reçus.

9. Appareil selon la revendication 8, dans lequel l'appareil est configuré pour ajuster la pondération de sorte que soit obtenue une formation de faisceau pour ajuster de manière variable une contribution d'un ou plusieurs des signaux reçus.

10. Appareil selon la revendication 9, dans lequel l'appareil est configuré pour filtrer individuellement au moins un des au moins deux signaux reçus et pour combiner en conséquence les au moins deux signaux reçus pour obtenir le signal de sortie, de sorte que le signal de sortie assure une sélectivité spatiale.

11. Appareil selon l'une des revendications 1 à 10, dans lequel l'appareil est configuré pour introduire la distorsion prédéterminée de sorte que soit émulée une atténuation d'un canal mobile entre l'élément de communication sans fil et l'appareil.

12. Appareil selon l'une des revendications 1 à 11, dans lequel l'appareil est configuré pour introduire la distorsion prédéterminée de sorte que l'appareil émule un mouvement de l'élément de communication sans fil.

13. Appareil selon l'une des revendications 1 à 12, dans lequel l'appareil est configuré pour introduire la distorsion prédéterminée de sorte que l'appareil émule une propagation par trajets multiples souhaitée.

14. Appareil selon l'une des revendications 1 à 13, dans lequel l'appareil est configuré pour obtenir les informations sur un environnement électromagnétique souhaité par l'intermédiaire d'une interface, et dans lequel l'appareil est configuré pour ajuster la distorsion prédéterminée selon les informations sur l'environnement électromagnétique souhaité et/ou pour régler un ajustement variable d'une contribution d'un ou plusieurs signaux reçus selon les informations sur l'environnement électromagnétique souhaité.

15. Appareil selon l'une des revendications 1 à 14, dans lequel l'appareil comprend un filtre qui est configuré pour compenser au moins partiellement une propagation par trajets multiples dans un environnement de caractérisation et/ou pour introduire une distorsion prédéterminée et/ou pour permettre un ajustement variable d'une contribution d'un ou plusieurs signaux reçus.

16. Système de mesure (1000; 1100) comprenant
un appareil selon l'une des revendications 1 à 15,
dans lequel l'appareil est disposé dans une chambre non anéchoïque.

17. Système de mesure selon la revendication 16, dans lequel le système comprend un évaluateur, et dans lequel l'évaluateur est configuré pour évaluer une performance de liaison entre les un ou plusieurs appareils et l'élément de communication sans fil.

18. Système de mesure selon la revendication 17, dans lequel l'évaluateur est configuré pour évaluer la performance de liaison en présence d'une atténuation émulée.

19. Système de mesure selon la revendication 17 ou 18, dans lequel l'évaluateur est configuré pour évaluer la performance de liaison en présence d'un mouvement émulé.

20. Procédé (1700) pour caractériser un élément de communication sans fil, comprenant le fait de
traiter (1710) un signal reçu de sorte que soit compensé au moins partiellement un effet de propagation par trajets multiples dans un environnement de caractérisation et de sorte que soit introduite une distorsion prédéterminée pour émuler ainsi un environnement électromagnétique virtuel;
dans lequel le procédé comprend le fait d'appliquer un filtrage invariable dans le temps pour introduire une contribution de filtrage statique pour compenser au moins partiellement un effet de propagation par trajets multiples, et dans lequel l'appareil est configuré pour appliquer une contribution de filtrage variable dans le temps pour introduire la distorsion prédéterminée.

21. Procédé (1700) pour caractériser un élément de communication sans fil, comprenant le fait de
traiter (1710) un signal reçu de sorte que soit compensé au moins partiellement un effet de propagation par trajets multiples dans un environnement de caractérisation et de sorte que soit introduite une distorsion prédéterminée pour émuler ainsi un environnement électromagnétique virtuel;
dans lequel le procédé comprend le fait d'appliquer une égalisation qui se comporte comme un filtre inverse d'un canal, et dans lequel est compensé au moins partiellement l'effet de propagation par trajets multiples, et
dans lequel le procédé comprend le fait d'introduire la distorsion prédéterminée en pondérant les valeurs spectrales du signal reçu par des coefficients d'atténuation prédéterminés.

22. Procédé (1700) pour caractériser un élément de communication sans fil, comprenant le fait de
traiter (1710) un signal reçu de sorte que soit compensé au moins partiellement un effet de propagation par trajets multiples dans un environnement de caractérisation et de sorte que soit introduite une distorsion prédéterminée pour émuler ainsi un environnement électromagnétique virtuel;
dans lequel le procédé comprend le fait d'appliquer une égalisation qui se comporte comme un filtre inverse d'un canal, et dans lequel est compensé au moins partiellement l'effet de propagation par trajets multiples, et
dans lequel le procédé comprend le fait d'effectuer une convolution du signal reçu par une réponse impulsionnelle prédéterminée, de sorte que la convolution atteigne la distorsion prédéterminée.

23. Procédé (1700) pour caractériser un élément de communication sans fil, comprenant le fait de
traiter (1710) un signal reçu de sorte que soit compensé au moins partiellement un effet de propagation par trajets multiples dans un environnement de caractérisation et de sorte que soit introduite une distorsion prédéterminée pour émuler ainsi un environnement électromagnétique virtuel;
dans lequel le procédé comprend le fait d'obtenir un filtre en utilisant une réception d'un signal de référence, et dans lequel l'appareil est configuré pour utiliser le filtre obtenu pour compenser au moins partiellement l'effet de la propagation par trajets multiples de l'environnement de caractérisation;
dans lequel le procédé comprend le fait d'appliquer une contribution de filtrage variable dans le temps pour introduire la distorsion prédéterminée, ou
dans lequel le procédé comprend le fait d'introduire la distorsion prédéterminée en pondérant les valeurs spectrales du signal reçu par des coefficients d'atténuation prédéterminés, ou
dans lequel le procédé comprend le fait d'effectuer une convolution du signal reçu par une réponse impulsionnelle prédéterminée, de sorte que la convolution atteigne la distorsion prédéterminée, ou
dans lequel le procédé comprend le fait de permettre, par une pluralité de sondes (910) configurées pour obtenir une pluralité de signaux reçus, un ajustement variable d'une contribution d'un ou plusieurs des signaux reçus à une fourniture d'un signal de sortie pour émuler ainsi un environnement électromagnétique virtuel.

24. Procédé (1700) pour caractériser un élément de communication sans fil, comprenant le fait de
traiter (1710) un signal reçu de sorte que soit compensé au moins partiellement un effet de propagation par trajets multiples dans un environnement de caractérisation et de sorte que soit introduite une distorsion prédéterminée pour émuler ainsi un environnement électromagnétique virtuel;
dans lequel le procédé comprend le fait d'appliquer une égalisation qui se comporte comme un filtre inverse d'un canal, et dans lequel est compensé au moins partiellement l'effet de propagation par trajets multiples, et
dans lequel le procédé comprend le fait d'effectuer un ajustement variable d'une contribution d'un ou plusieurs signaux reçus, obtenu à l'aide d'une pluralité de sondes, à une fourniture d'un signal de sortie, émuler ainsi un environnement électromagnétique virtuel.

25. Programme d'ordinateur avec un code de programme pour réaliser l'un des procédés selon les revendications 20 à 24 lorsque le programme d'ordinateur est exécuté sur un ordinateur ou un microcontrôleur.
